# EUROPÄISCHE PATENTSCHRIFT

(11) **EP 3 014 656 B1**
(45) Veröffentlichungstag und Bekanntmachung des Hinweises auf die Patenterteilung: **25.12.2019**
(21) Anmeldenummer: 14732571.6
(22) Anmeldetag: 25.06.2014
(51) Int. Cl.: H01L 23/522, H01F 17/00

(54) **BAUELEMENTANORDNUNG**
COMPONENT ARRANGEMENT
AGENCEMENT DE COMPOSANTS

(30) Priorität: 26.06.2013 DE 102013106693
(43) Veröffentlichungstag der Anmeldung: 04.05.2016
(73) Patentinhaber: Technische Universität Dresden, 01069 Dresden (DE)
(72) Erfinder: ELLINGER, Frank, 01069 Dresden (DE); HENKER, Ronny, 01307 Dresden (DE); BELFIORE, Guido, 01187 Dresden (DE); THIELE, Christian, 01187 Dresden (DE)
(74) Vertreter: Viering, Jentschura & Partner mbB Patent- und Rechtsanwälte
(86) Internationale Anmeldenummer: PCT/EP2014/063421
(87) Internationale Veröffentlichungsnummer: WO 2014/207051

(56) Entgegenhaltungen:
- US-A1- 2010 225 400
- US-A1- 2010 289 118
- US-A1- 2013 113 448

## Beschreibung

Zur Realisierung einer elektrischen oder einer elektronischen Schaltung werden neben aktiven Bauelementen, wie z.B. Transistoren, passive Bauelemente benötigt. Eines der wichtigsten passiven Bauelemente stellt, neben Widerständen und Kondensatoren, eine Spule dar. Eine Spule besteht in der Regel aus gewickelten oder spiralförmigen Leiterschleifen. Die Eigenschaften, beispielsweise die Induktivität, der Spule hängen üblicherweise maßgeblich von den verwendeten Materialien, der Anzahl der Windungen (Spulenwindungen, Spulenwicklungen) sowie den physischen Abmessungen, wie dem Durchmesser des Leiters, der Größe der Spule usw., ab. Eine Spule wird häufig in einem frequenzbestimmten bzw. - bestimmenden Schaltkreis wie z.B. einem Oszillator oder einem Filter, sowie in einer Schaltung zur Stromglättung oder in einem Netzteil verwendet. In einer hochfrequenten/breitbandigen Verstärkerschaltung kommt eine Spule vorwiegend zur Verbesserung der Verstärkercharakteristik, d.h. zur Erhöhung der Bandbreite und/oder zur Glättung des Amplitudenganges, sowie zur Verbesserung der Ein-/Ausgangsanpassung zur Anwendung.

Im Zuge der Miniaturisierung und in der heutigen Mikroelektronik werden die elektronischen Bauelemente mittels Halbleitertechnologie integriert und bilden einen Chip, welcher wiederum ein komplexes elektronisches Bauelement mit neuer Funktion darstellt. Die einzelnen Elemente der mikroelektronischen Schaltungen werden dabei auf einem Halbleitersubstrat, dem sogenannten Wafer, durch entsprechende Dotierung/Legierung sowie durch gezieltes Aufbringen funktionaler Metallschichten (im Folgenden auch bezeichnet als Metalllagen oder Metallebenen oder Metallisierungsebenen oder Metallisierungsschichten) erzeugt. Dadurch entsteht eine Struktur von mehreren horizontalen Metallschichten (auch bezeichnet als Metallstapel, der abhängig von der jeweiligen Technologiespezifikation ist), die voneinander elektrisch isoliert sind und mittels Durchkontaktierungen (so genannte vertical interconnect access, vias), im Folgenden auch bezeichnet als Kontaktdurchführungen, Zwischenebenenverbindung) miteinander verbunden werden können; ähnlich wie bei einer mehrschichtigen Leiterplatte. Die Bezeichnung der Ausrichtung als horizontal ist hierbei durch die Ebene/Lage des Halbleitersubstrates definiert. Damit sind die einzelnen Metalllagen parallel zueinander und parallel zum Substrat angeordnet; liegen also in der horizontalen Ebene. Eine vertikale Ausrichtung bezeichnet damit eine Ebene, die senkrecht zum Substrat und zu den einzelnen Metalllagen liegt.

Wird eine Spule in einer solchen Halbleitertechnologie integriert, so geschieht dies heutzutage meist auf einer horizontalen Metallebene, indem Leiterbahnen mit einer bestimmten Breite spiralförmig angeordnet werden. Durch diese horizontale Anordnung nimmt die Spule eine sehr große Fläche ein und ist nicht selten größer als der übrige Schaltungsteil. Da die Kosten in der Halbleiterindustrie auf die verwendete Chipfläche berechnet werden, stellt die Spule damit den größten Kostenfaktor in einer solchen Schaltung dar.

Bisher wird eine Spule und damit die Spulenwindungen, in der horizontalen Ebene eines Chips integriert [Chen, J. & Liou, J. J., On-Chip Spiral Inductors for RF Applications: An overview, J. Semiconductor Techn. Sei. 4, 149 (2004)]. Hierzu wird ein metallischer Streifenleiter mit einer bestimmten Breite spiralförmig auf einer Metalllage im Metallstapel angeordnet. Dies erfolgt auf einer der oberen Metalllagen des Metallstapels. Ein Anschluss der Spule wird dann vom äußeren Rand der Leiterstreifenspirale als Verbindung nach außen geführt. Da es auf der Metalllage keine Kreuzung von Streifenleitern geben darf, wird der zweite Anschluss der Spule vom Inneren der Spirale über eine Durchkontaktierung auf eine höhere oder niedrigere Metalllage im Metallstapel geführt und von dort aus wird die Verbindung hergestellt.

Darüber hinaus gibt es auch Spulen, welche zwar als vertikale Spulen bezeichnet werden, die aber nicht ausschließlich, die vertikale Ebene nutzen bzw. plan in der vertikalen Ebene liegen. Vielmehr wird zwar bei einer solchen Anordnung der Streifenleiter von einer zur nächsten Metallebene geführt, die eigentlichen Spulenwindungen liegen aber in der horizontalen Ebene, womit der von den Spulenwindungen definierte Spulenbereich in der horizontalen Ebene und damit parallel zu der Hauptprozessierungsoberfläche des Substrats liegt. Dadurch entsteht beispielsweise eine Spule in Form einer Zylinderspule [Tsui, H.-Y. et. al., An On-Chip Vertical Solenoid Inductor Design for Multigigahertz CMOS RFIC, IEE Transactions on Microwave Theory and Technique 53, 1883 (2005)]. Des Weiteren können Spulen miteinander verbunden bzw. kaskadiert werden. Diese Anordnungen sind als gestapelte integrierte Spulen [Yousef, K. et al., Design of 3D Integrated Inductors for RFICs, Japan-Egypt Conf. on Electronics, Communications and Computers (JEC-ECC), 22 (2012)] bekannt. Ferner gibt es schraubenartige Anordnungen, bei denen einzelne vertikale Leiterschleifen horizontal miteinander verbunden sind [US 2012/0268229 A1].

In der Druckschrift US 2010/225400 A1 wird ein Transformator auf einen integrierten Schaltkreis beschrieben, wobei der integrierte Schaltkreis mehrere Metallisierungsschichten mit metallischen Kopplungsstrukturen aufweist.

In der Druckschrift US 2010/289118 A1 wird ein mehrschichtiger Induktor mit mehreren Durchkontaktierungen beschrieben.

In der Druckschrift US 2013/0113448 A1 wird eine Spule auf einem Halbleiterchip beschrieben, wobei der Halbleiterchip mehrere Metallisierungsschichten mit metallischen Kopplungsstrukturen und zusätzliche Durchkontaktierungen aufweist.

Verschiedene Ausführungsformen stellen eine Spule mit einem reduzierten Flächenbedarf bereit.

Verschiedene Ausführungsformen stellen eine Spule bereit unter der Verwendung der Metallisierungsschichten der Bauelementanordnung und ihrer Durchkontaktierungen, wobei die Metallisierungsschichten und deren Durchkontaktierungen derart miteinander elektrisch leitend verbunden werden zum Beispiel mit Hilfe von elektrisch leitfähigen Leitungsstrukturen, dass sie eine Spule mit reduziertem Flächenbedarf bilden, die einen Spulenbereich aufweist, der in einem Winkel zu der Hauptprozessierungsoberfläche des Trägers der Bauelementanordnung liegt. Der Winkel, gebildet zwischen dem Spulenbereich und der Hauptprozessierungsebene, liegt hierbei zum Beispiel in einem Bereich von größer als 0° bis zu 90°, gemäß einer Ausführungsform in einem Bereich von größer als 0° bis zu 85°. Durch die Bereitstellung einer Spule mit reduziertem Flächenbedarf, deren Spulenbereich in einem Winkel zu der Hauptprozessierungsebene des Trägers liegt, wird eine Reduzierung der benötigten Chipfläche und der damit verbundenen Chip- und Materialkosten realisiert. Für die Realisierung der elektrisch leitfähigen Leitungsstrukturen, welche unterschiedliche Metallisierungsschichten der Bauelementanordnung und deren Durchkontaktierung derart elektrisch leitfähig verbinden, dass sie eine Spule bilden, können die im herkömmlichen Herstellungsprozess für die Realisierung der Metallisierungsschichten, der metallischen Kopplungsstrukturen und dem Füllen der Durchkontaktierungen verwendeten Materialien und Verfahren eingesetzt werden. Dies ermöglicht eine Integration der, durch die vorliegende Offenbarung bereitgestellten, Spule mit einem reduzierten Flächenbedarf in den herkömmlichen Herstellungsprozess und damit verbunden einer Kostenersparnis. Zudem ermöglicht die in der vorliegenden Offenbarung bereitgestellte Bauelementanordnung die Realisierung von Spulen mit reduziertem Flächenbedarf auch in der 3D-Integration mehrerer Chips unter der zusätzlichen Verwendung der Silizium-Durchkontaktieren bzw. der Verwendung der Zwischenträger-Durchkontaktierungen im Rahmen des Herstellungsprozesses der 3D-Chipintegration.

Verschiedene Ausführungsformen stellen eine Bauelementanordnung bereit, wobei die Struktur der Bauelementanordnung folgende Merkmale aufweist: einen Träger, wobei in dem Träger mindestens ein elektronisches Bauelement gebildet wird; eine erste Metallisierungsschicht über dem Träger, wobei die erste Metallisierungsschicht eine erste metallische Kopplungsstruktur aufweist, die mit dem mindestens einen elektronischen Bauelement elektrisch gekoppelt wird; eine zweite Metallisierungsschicht über der ersten Metallisierungsschicht, wobei die zweite Metallisierungsschicht eine zweite metallische Kopplungsstruktur aufweist, wobei die erste metallische Kopplungsstruktur mittels mindestens einer Durchkontaktierung mit der zweiten metallischen Kopplungsstruktur gekoppelt wird; und mehrere zusätzliche Durchkontaktierungen, die sich zumindest zwischen der ersten Metallisierungsschicht und der zweiten Metallisierungsschicht erstrecken und die miteinander elektrisch leitend gekoppelt werden derart, dass sie eine Spule bilden, die einen Spulenbereich aufweist, der in einem Winkel zu der Hauptprozessierungsoberfläche des Trägers liegt.

In einer Ausgestaltung weist die Bauelementanordnung einen Träger, z.B. ein Substrat, z.B. ein Halbleitersubstrat, auf. In noch einer Ausgestaltung weist der Träger mindestens ein elektronisches Bauelement aus der nachfolgenden Gruppe von elektronischen Bauelementen auf oder ist als ein solches eingerichtet: Widerstand, Diode, Transistor, Kondensator, Spule, Thyristor, Solarzelle, elektrooptisches Bauelement, mikromechanisches Bauelement.

In einer Ausgestaltung weist die Bauelementanordnung eine erste Metallisierungsschicht auf, welche unmittelbar über dem Träger, welcher das mindestens eine integrierte Bauelement aufweist, angeordnet ist, wobei die erste Metallisierungsschicht mindestens eines der folgenden Materialien aufweisen kann oder aus einem solchen bestehen kann: Aluminium (Al) und Kupfer (Cu) oder einer Legierung der genannten Metalle.

In noch einer Ausgestaltung weist die Bauelementanordnung eine erste metallische Kopplungsstruktur, z.B. eine Metallleiterbahn (metallenthaltende Leiterbahn, Leitbahn, Leitungsbahn), z.B. eine niederohmige metallische Leiterbahn, gebildet in der ersten Metallisierungsschicht, auf, die die elektrische Verwendung innerhalb der Metallisierungsschicht, als Metallleiterbahn hoher elektrischer Leitfähigkeit, realisiert. Die erste metallische Kopplungsstruktur wird mit dem mindestens einen elektronischen Bauelement elektrisch leitend gekoppelt.

Es ist in diesem Zusammenhang darauf hinzuweisen, dass in verschiedenen Ausführungsbeispielen (beispielsweise abhängig von den jeweils verwendeten Technologien) eine unterschiedliche Anzahl von Metallisierungsebenen mit variierenden Dicken und Abständen vorgesehen sein können, über die sich die Spule erstrecken kann, beispielsweise drei Metallisierungsebenen oder mehr als drei Metallisierungsebenen, beispielsweise 4, 5, 6, 7, 8, 9, 10, 11, 12, oder sogar mehr Metallisierungsebenen.

In noch einer Ausgestaltung weist die Bauelementanordnung eine zweite Metallisierungsschicht über der ersten Metallisierungsschicht auf, wobei die zweite Metallisierungsschicht eine zweite metallische Kopplungsstruktur aufweist, wobei eine elektrische leitende Verbindung zwischen der ersten metallische Kopplungsstruktur und der zweiten metallischen Kopplungsstruktur mit Hilfe mindestens einer Durchkontaktierung realisiert wird. Die mindestens eine Durchkontaktierung stellt beispielsweise eine elektrisch leitende Verbindung als eine vertikale elektrische Verbindung zwischen zwei benachbarten gestapelten Metallisierungsschichten bereit.

In noch einer Ausgestaltung weist die Bauelementanordnung mehrere zusätzliche Durchkontaktierungen, als vertikale elektrische Verbindungen, auf, wobei sich die mehreren zusätzlichen Durchkontaktierungen zumindest zwischen der ersten Metallisierungsschicht und der zweiten Metallisierungsschicht erstrecken. Die mehreren zusätzlichen Durchkontaktierungen werden in noch einer Ausgestaltung derart elektrisch leitend gekoppelt, dass sie eine Spule bilden, wobei die Spule einen Spulenbereich aufweist, welcher in einem Winkel zu der Hauptprozessierungsebene des Trägers liegt.

Unter Hauptprozessierungsebene kann im Zusammenhang der vorliegenden Offenbarung eine Seite (Oberfläche, Ebene) des Trägers verstanden werden, auf welcher üblicherweise die Prozessierungsschritte der Fertigung von Halbleiterchips und integrierten Schaltungen, z.B. Lithographie, Ätzen, Strukturierungsverfahren, Abscheidung von Metallisierungsschichten, Abscheidung von Kontakten, und dergleichen, erfolgen.

Unter Spulenbereich kann im Zusammenhang der vorliegenden Offenbarung, ein Bereich des Metallstapels verstanden werden, welcher z.B. eine erste Metallisierungsschicht und eine zweite Metallisierungsschicht aufweist, und welcher die für die Bildung der Spule in dem Metallstapel benötigte Fläche, aufweisend eine Länge LS und eine Breite BS, definiert, wobei der Spulenbereich, derart gebildet wird, dass er in einem Winkel zu der Hauptprozessierungsebene des Trägers liegt.

In noch einer Ausgestaltung weist der Träger ein Halbleitermaterial auf.

In noch einer Ausgestaltung weist der Träger mindestens ein Halbleitermaterial aus der nachfolgenden Gruppe an Halbleitermaterialien auf: Silizium, Germanium, Gruppe III bis V Materialien, Polymeren. Gemäß einer Ausgestaltung weist der Träger einen Silizium-auf-Isolator SOI-Wafer (Silicon on Insulator, SOI) auf. Gemäß einer weiteren Ausgestaltung weist der Träger dotiertes oder undotiertes (nicht-dotiertes) Silizium auf. Gemäß einer Ausführungsform weist der Träger ein Halbleiterverbindungsmaterial, z.B. Galliumarsenid (GaAs), z.B. Indiumphosphid (InP) auf. Gemäß einer weiteren Ausgestaltung weist der Träger ein ternäres Halbleiterverbindungsmaterial auf, z.B. Indium-GalliumArsenid (InGaAs).

In noch einer Ausgestaltung weisen die erste metallische Kopplungsstruktur und/oder die zweite metallische Kopplungsstruktur eine Mehrzahl von Metallleiterbahnen auf.

Gemäß einer Ausführungsform weisen die erste metallische Kopplungsstruktur und/oder die zweite metallische Kopplungsstruktur mindestens eines der folgenden Metalle auf: Kupfer, Aluminium, Platin, Gold, Silber, Palladium, Nickel, oder eine Legierung der genannten Metalle.

Gemäß einer Ausführungsform weist die Bauelementanordnung ferner eine dritte Metallisierungsschicht über der zweiten Metallisierungsschicht auf, wobei die dritte Metallisierungsschicht eine dritte metallische Kopplungsstruktur aufweist, und wobei die zweite metallische Kopplungsstruktur mittels mindestens einer Durchkontaktierung mit der dritten metallischen Kopplungsstruktur elektrisch leitend gekoppelt wird; und wobei sich die zusätzlichen Durchkontaktierungen zumindest zwischen der ersten Metallisierungsschicht und der dritten Metallisierungsschicht erstrecken.

Gemäß einem Beispiel weist die Spule ferner Leitungsstrukturen auf, welche die zusätzlichen Durchkontaktierungen miteinander elektrisch koppeln; und wobei die Leitungsstrukturen in der ersten Metallisierungsschicht und/oder der zweiten Metallisierungsschicht verlaufen.

Unter einer Leitungsstruktur kann im Rahmen dieser Anmeldung allgemein eine Metallbahn (metallische Bahn) verstanden werden, welche derart in einer Metallisierungsschicht gebildet werden, dass sie durch elektrisches Verbinden der zusätzlichen Durchkontaktierungen eine Spule (Spule als induktives passives Bauelemente, die eine definierte Induktivität aufweist) bildet. Die Leitungsstruktur kann mindestens ein Material aus der nachfolgenden Gruppe von Materialien aufweisen, ohne darauf beschränkt zu sein: Nickel (Ni), Eisen (Fe), Kupfer (Cu), Aluminium (Al) oder eine Legierung der genannten Metalle.

Die Leitungsstruktur kann beispielsweise mittels eines der folgenden Verfahren gebildet werden: thermisches Verdampfen, chemische Gasphasenabscheidung, Elektronenstrahlverdampfung, Kathodenzerstäubung (Sputtern), z.B. Gleichstrom-Kathodenzerstäubung, z.B. Bias- Kathodenzerstäubung, Einlegetechnik, Damaszenertechnik.

Gemäß einer Ausführungsform weist die Spule mindestens eine Spulenwindung auf; wobei die mindestens eine Spulenwindung den Spulenbereich definiert.

Unter einer Spulenwindung kann in diesem Zusammenhang eine elektrische leitende Kopplung einer elektrisch leitfähigen Leitungsstruktur in zumindest einer ersten Metallisierungsschicht mit einer Leitungsstruktur in zumindest einer zweiten Metallisierungsschicht mittels der mehreren zusätzlichen Durchkontaktierungen verstanden werden, derart, dass die gebildete Spulenwindung eine Induktivität bei Stromfluss erzeugen kann. Die Spulenwindung muss dabei mindestens eine volle Windung besitzen.

Die mindestens eine gebildete Spulenwindung definiert den Spulenbereich derart, dass sie die für die Bildung der Spule benötigte Fläche abgrenzt (definiert).

Gemäß einer weiteren Ausführungsform weist die Spule mehrere Spulenwindungen auf.

Gemäß einer Ausführungsform erstrecken sich die mehreren zusätzlichen Durchkontaktierungen derart, zumindest zwischen der ersten Metallisierungsschicht und der zweiten Metallisierungsschicht, dass der Spulenbereich in einem Winkel zu der Hauptprozessierungsoberfläche des Trägers liegt.

Somit kann ein Vorteil verschiedener Ausführungsbeispiele darin liegen, dass die Leitungsstrukturen zur Bildung der Spule in einem Winkel zur Hauptprozessierungsebene angeordnet werden, was zu einer erheblichen Einsparung des Platzbedarfs (bezogen auf die zur Verfügung stehende aktive Fläche des Substrats, in der beispielsweise elektronische Halbleiterbauelemente oder Halbleiter-Schaltkreise realisiert werden können) einer Spule in einem Substrat führt. Es werden die Leitungsstrukturen in den gestapelten Metallisierungsschichten mittels der mehreren zusätzlichen Durchkontaktierungen beispielsweise derart verbunden, dass eine oder mehr Spulenwindungen in einer Ebene in einem Winkel zur Hauptprozessierungsebene des Trägers gebildet werden. Eine solche in einem Winkel zur Hauptprozessierungsebene des Trägers integrierte Spule reduziert somit den Flächenbedarf einer in einen Chip integrierten Spule und senkt die Kosten für einen Chip.

Eine Bauelementanordnung gemäß einer weiteren Ausführungsform weist ferner auf: einen zusätzlichen Träger; erste zusätzliche Metallisierungsschicht über dem zusätzlichen Träger; wobei die erste zusätzliche Metallisierungsschicht mit mehreren zusätzlichen Durchkontaktierungen gekoppelt wird, so dass ein Teil der ersten zusätzlichen Metallisierungsschicht einen Teil der Spule bildet.

Der zusätzliche Träger kann den gleichen oder einen ähnlichen Aufbau aufweisen wie der oben beschriebene Träger.

Gemäß einer Ausführungsform weist die Bauelementanordnung ferner auf: eine zweite zusätzliche Metallisierungsschicht über der ersten zusätzlichen Metallisierungsschicht, wobei die zweite zusätzliche Metallisierungsschicht mit der ersten zusätzlichen Metallisierungsschicht elektrisch leitend gekoppelt ist, wobei ein Teil der zweiten zusätzlichen Metallisierungsschicht einen Teil der Spule bildet.

Gemäß einer Ausführungsform weist der zusätzliche Träger mindestens ein zusätzliches elektronisches Bauelement auf, das in dem Träger gebildet ist.

Gemäß einer Ausführungsform weist die Bauelementanordnung ferner auf: mehrere zusätzliche Durchkontaktierungen, die sich zumindest zwischen der ersten zusätzlichen Metallisierungsschicht und der zweiten zusätzlichen Metallisierungsschicht erstrecken, und die einen Teil der Spule bilden.

Gemäß einer Ausführungsform weist die Bauelementanordnung ferner auf: einen Zwischenträger mit mehreren Zwischenträger-Durchkontaktierungen; wobei die Zwischenträger-Durchkontaktierungen einen Teil der Spule bilden.

Eine solche Bauelementanordnung ermöglicht die Reduzierung der, für die Realisierung einer Spule in einem Chip, benötigten Chipfläche, und der damit verbundenen Chip-/Materialkosten. Weiterhin kann durch die Verringerung der Chipfläche ein höherer Miniaturisierungsgrad erreicht werden. Eine Integration vertikaler Spulen in einem 3D Chip-Stapel über mehrere übereinander liegende Chips hinweg ist sehr vorteilhaft, weil dadurch integrierte Spulen mit relativ großer Induktivität realisiert werden können.

Die oben und im Folgenden beschriebenen Metallisierungsschichten (beispielsweise die erste Metallisierungsschicht, die zweite Metallisierungsschicht, die dritte Metallisierungsschicht, die erste zusätzliche Metallisierungsschicht, die zweite zusätzliche Metallisierungsschicht, die Kopplungsstrukturen) können mittels eines der folgenden Verfahren gebildet werden: thermisches Verdampfen, chemische Gasphasenabscheidung, Elektronenstrahlverdampfung, Kathodenzerstäubung (Sputtern), z.B. Gleichstrom-Kathodenzerstäubung, z.B. Bias-Kathodenzerstäubung, Einlegetechnik, Damaszenertechnik.

In den Zeichnungen verweisen gleiche Bezugszeichen auf die gleichen Teile in den verschiedenen Ansichten. Die Zeichnungen sind nicht zwangsläufig maßstabsgerecht, der Schwerpunkt wird stattdessen allgemein auf die Darstellung der Prinzipien der Erfindung gelegt. In der nachfolgenden Beschreibung der Erfindung, sind verschiedene Ausführungsformen in Bezug auf die folgenden Zeichnungen beschrieben, in welchen:
Figuren 1A bis IE zeigen eine Bauelementanordnung gemäß einem Beispiel.
Figuren 2A bis 2C zeigen eine Bauelementanordnung gemäß einem Beispiel.
Figuren 3A bis 3F zeigen eine Bauelementanordnung gemäß einem Beispiel.
Figur 4 zeigt eine Bauelementanordnung gemäß einer Ausführungsform.
Figuren 5A und B zeigen eine Bauelementanordnung gemäß einer weiteren Ausführungsform.

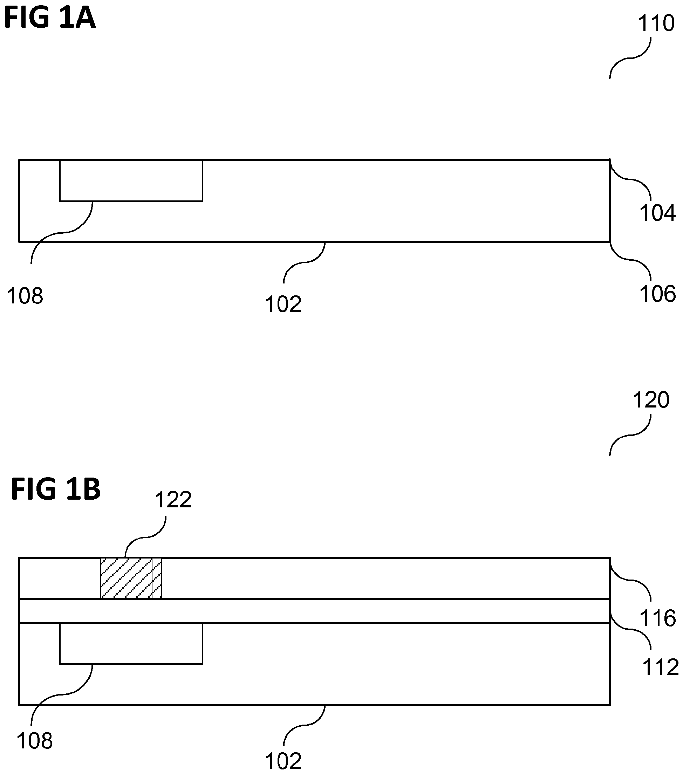

**Fig.1A bis Fig.1E** zeigen eine Bauelementanordnung gemäß einem Beispiel.

Die Bauelementanordnung kann aufweisen: einen Träger 102, z.B. ein Substrat, z.B. ein Halbleitersubstrat. Die Bauelementanordnung kann aufweisen mindestens ein elektronisches Bauelement 108, das in dem Träger 102 gebildet sein kann. Die Bauelementanordnung kann ferner eine erste Metallisierungsschicht 116 aufweisen, wobei die erste Metallisierungsschicht 116 eine erste metallische Kopplungsstruktur 122 aufweisen kann, die mit dem mindestens einen elektronischen Bauelement 108 elektrisch leitend gekoppelt ist. Die Bauelementanordnung kann eine zweite Metallisierungsschicht 128, die über der ersten Metallisierungsschicht 116 gebildet sein kann, aufweisen, wobei die zweite Metallisierungsschicht 128 eine zweite metallische Kopplungsstruktur 132 aufweisen kann und wobei die erste metallische Kopplungsstruktur 122 mit der zweiten metallischen Kopplungsstruktur 132 mit Hilfe mindestens einer Durchkontaktierung 134 (vertical interconnect access, via) elektrisch leitend verbunden sein kann. Die Bauelementanordnung kann mehrere zusätzliche Durchkontaktierungen 136, 138, 142 aufweisen, die sich zumindest zwischen der ersten Metallisierungsschicht 116 und der zweiten Metallisierungsschicht 128 erstrecken können und die miteinander derart elektrisch leitend gekoppelt sein können, dass sie eine Spule bilden, die einen Spulenbereich aufweisen kann, der in einem Winkel zu der Hauptprozessierungsebene des Trägers 102 liegen kann.

In verschiedenen Beispielen kann der Winkel in einem Bereich von größer als 0° bis zu 90° zu der Hauptprozessierungsebene des Trägers 102 liegen, beispielsweise in einem Bereich von größer als 20° bis zu 90°, beispielsweise in einem Bereich von größer als 40° bis zu 90°, beispielsweise in einem Bereich von größer als 60° bis zu 90°, beispielsweise in einem Bereich von größer als 80° bis zu 90°, beispielsweise in einem Bereich von größer als 85° bis zu 90°, beispielsweise von ungefähr 90°. Gemäß verschiedenen Ausführungsformen kann der Winkel in einem Bereich zwischen 0° und 85° liegen.

In 110 (siehe Fig.1A)kann die Bauelementanordnung 110 einen Träger 102, z.B. ein Substrat, z.B. ein Halbleitersubstrat, aufweisen. Der Träger 102 kann eine Trägeroberseite 104 und eine Trägerunterseite 106 aufweisen, welche einander gegenüberliegend angeordnet sind, und wobei die Trägeroberseite 104 die Hauptprozessierungsebene des Trägers 102 bildet.

Der Träger 102 kann mindestens ein Halbleitermaterial aus der nachfolgenden Gruppe von Halbleitermaterialien aufweisen, ohne darauf beschränkt zu sein: Silizium, Germanium, Gruppe III bis V Materialien, Polymeren. Gemäß einer weiteren Ausgestaltung kann der Träger 102 dotiertes oder undotiertes (nicht-dotiertes) Silizium aufweisen. Gemäß einer Ausgestaltung kann der Träger 102 einen Silizium-auf-Isolator SOI-Wafer (Silicon on Insulator, SOI) aufweisen. Gemäß einer anderen Ausgestaltung kann der Träger 102 ein Halbleiterverbindungsmaterial, z.B. Galliumarsenid (GaAs), z.B. Indiumphosphid (InP) aufweisen. Gemäß einer weiteren Ausgestaltung kann der Träger 102 ein ternäres Halbleiterverbindungsmaterial aufweisen, z.B. Indium-GalliumArsenid (InGaAs).

Die Bauelementanordnung 110 kann den Träger 102 aufweisen, wobei in dem Träger 102 mindestens ein elektronisches Bauelement 108, beispielsweise ein aktives elektronisches Bauelement, gebildet sein kann. Das mindestens eine elektronische Bauelement 108 kann mindestens eines der folgenden elektronischen Bauelemente aufweisen oder als ein solches eingerichtet sein: Diode, Transistor, Thyristor, Solarzelle, elektrooptisches Bauelement, mikromechanisches Bauelement.

In 120 kann, in der Bauelementanordnung 120, über dem Träger 102, z.B. der Trägeroberseite 104, z.B. der Hauptprozessierungsebene des Trägers 102, eine erste dielektrische Zwischenschicht 112 gebildet werden. Die erste dielektrische Zwischenschicht 112 kann ein dielektrisches Material aufweisen. Das dielektrische Material kann mindestens eines der folgenden Materialien aufweisen: Oxid(e), z.B. Siliziumdioxid (Si02), z.B. kohlenstoffdotiertem Oxid (carbon doped oxide, CDO), Siliziumnitrid (Si3N4), low-k dielektrischen Materialien, z.B. Black Diamond, organischen Polymeren, z.B. Perfluorcyclobutan, z.B. Polytetrafluorethylen, Fluorsilikatglas (fluorsilicate glass, FSG), Organosilikaten, z.B. Silsesquioxan, z.B. Siloxan, z.B. Organosilikatglas. Das dielektrische Material kann Poren oder Leerstellen aufweisen. Das dielektrische Material kann mittels verschiedener herkömmlicher Verfahren gebildet werden. Das dielektrische Material kann beispielsweise mittels thermischer Oxidation, chemischer Gasphasenabscheidung (Chemical Vapour Deposition, CVD), Spin-on-Technologie gebildet werden.

Über der ersten dielektrischen Zwischenschicht 112 kann, in der Bauelementanordnung 120 (siehe **Fig.1B****),** eine erste Metallisierungsschicht 116 gebildet werden, wobei die erste Metallisierungsschicht 116 ein erstes elektrisch leitfähiges Material aufweisen kann.

Das erste elektrisch leitfähige Material kann mindestens eines der folgenden Materialien aufweisen, ohne darauf beschränkt zu sein, oder kann aus einem solchen bestehen: Aluminium (Al) und Kupfer (Cu) oder einer Legierung der genannten Metalle. Das erste elektrisch leitfähige Material kann gebildet werden mittels verschiedener herkömmlicher Verfahren, beispielsweise mittels thermischen Verdampfens, chemischer Gasphasenabscheidung, Elektronenstrahlverdampfung, Kathodenzerstäubung (Sputtern), z.B. Gleichstrom-Kathodenzerstäubung, z.B. Bias-Kathodenzerstäubung, Einlegetechnik, Damaszenertechnik.

Die erste Metallisierungsschicht 116 kann eine erste metallische Kopplungsstruktur 122 (metallenthaltende Leiterbahn, Leitbahn, Leitungsbahn) z.B. eine niederohmige metallische Leiterbahn, die die elektrische Verwendung innerhalb der Metallisierungsschicht als Metallleiterbahn hoher elektrischer Leitfähigkeit, realisiert, aufweisen. Die erste metallische Kopplungsstruktur 122 kann ein zweites elektrisch leitfähiges Material aufweisen. Das zweite elektrisch leitfähige Material kann mindestens eines aus der nachfolgenden Gruppe von Materialien aufweisen: Kupfer (Cu), Aluminium (Al), Platin (Pt), Gold (Au), Silber (Ag), Palladium (Pd), Nickel (Ni) oder eine Legierung der genannten Metalle. Das zweite elektrisch leitfähige Material kann mittels verschiedener herkömmlicher Verfahren gebildet werden, beispielsweise mittels thermischen Verdampfens, chemischer Gasphasenabscheidung, Elektronenstrahlverdampfung, Kathodenzerstäubung (Sputtern), z.B. Gleichstrom-Kathodenzerstäubung, z.B. Bias-Kathodenzerstäubung, Einlegetechnik, Damaszenertechnik. Die erste metallische Kopplungsstruktur 122 kann eine Mehrzahl von Metallleiterbahnen aufweisen. Ferner kann die erste metallische Kopplungsstruktur 122 kann elektrisch leitend gekoppelt werden mit dem mindestens einen elektronischen Bauelement 108. Die erste metallische Kopplungsstruktur 122 kann somit Leiterbahnen aufweisen, die mittels eines Dielektrikums voneinander elektrisch isoliert sein können.

In 130 kann eine zweite dielektrische Zwischenschicht 126 gebildet werden über der ersten Metallisierungsschicht 116. Die zweite dielektrische Zwischenschicht 126 kann ein dielektrisches Material aufweisen. Das dielektrische Material kann dasselbe oder ein anderes dielektrisches Material aufweisen wie das dielektrische Material der ersten dielektrischen Zwischenschicht 112.

Anschließend kann über der zweiten dielektrischen Zwischenschicht 126 eine zweite Metallisierungsschicht 128 gebildet werden. Die zweite Metallisierungsschicht 128 kann das erste elektrisch leitfähige Material aufweisen. Das erste elektrisch leitfähige Material kann dasselbe oder ein anderes erstes elektrisch leitfähiges Material aufweisen wie das erste elektrisch leitfähige Material der ersten Metallisierungsschicht 116.

Die zweite Metallisierungsschicht 128 kann eine zweite metallische Kopplungsstruktur 132 aufweisen, welche das zweite elektrisch leitfähige Material aufweisen kann. Das zweite elektrisch leitfähige Material kann dasselbe oder ein anderes zweites elektrisch leitfähiges Material aufweisen wie das zweite elektrisch leitfähige Material der ersten metallischen Kopplungsstruktur 122. Die zweite metallische Kopplungsstruktur 132 kann somit Leiterbahnen aufweisen, die mittels eines Dielektrikums voneinander elektrisch isoliert sein können.

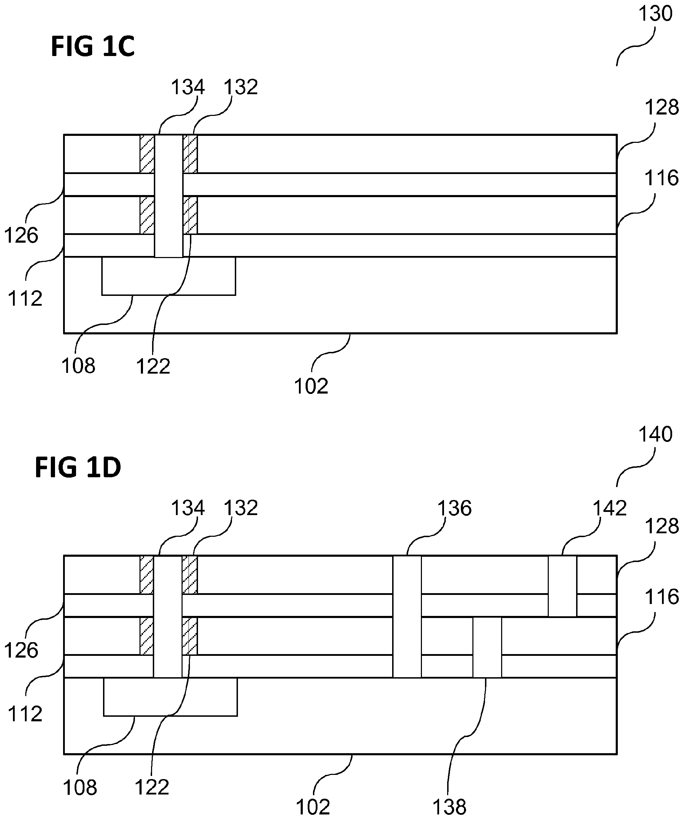

In **Fig.1C** kann in der Bauelementanordnung 130 die erste metallische Kopplungsstruktur 122 mit der zweiten metallischen Kopplungsstruktur 132 mittels mindestens einer Durchkontaktierung 134 elektrisch leitend gekoppelt werden, wobei sich die mindestens eine Durchkontaktierung 134 durch zwischen dem Träger 102 und der zweiten Metallisierungsschicht 128 und/oder zwischen dem Träger 102 und der ersten Metallisierungsschicht 116 und/oder zwischen der ersten Metallisierungsschicht 116 und der zweiten Metallisierungsschicht 128 erstrecken kann.

Die mindestens eine Durchkontaktierung 134 kann gebildet werden mittels verschiedener herkömmlicher Verfahren. Beispielsweise kann gemäß einer Ausgestaltung die mindestens eine Durchkontaktierung 134 gebildet werden unter Verwendung eines Bohrprozesses, z.B. eines Laserbohrprozesses, oder mittels eines Lithographieprozesses, einschließlich eines oder mehrerer Belichtungsprozesse und eines oder mehrerer Ätzprozesse. Der Laserbohrprozess kann durchgeführt werden, z.B. unter Einsatz eines Lasers, z.B. eines CO₂-Lasers. Das Laserbohren kann durchgeführt werden um die mindestens eine Durchkontaktierung 134, d.h. ein Loch, zu erzeugen. In einer anderen Ausgestaltung kann die mindestens eine Durchkontaktierung 134, beispielsweise, gebildet werden mittels mechanischen Bohrens. In einer weiteren Ausgestaltung kann die mindestens eine Durchkontaktierung 134 eine vorgefüllte Durchkontaktierung aufweisen. Die Art der gebildeten mindestens einen Durchkontaktierung 134 ist nicht beschränkt in Bezug auf die Verwendung der Bauelementanordnung, welche der Gegenstand dieser Offenbarung ist.

Im Anschluss kann ein Füllen (filling) der mindestens einen Durchkontaktierung 134 mittels verschiedener herkömmlicher Verfahren durchgeführt werden um eine Kontaktmetallisierung bereitzustellen. Die mindestens eine Durchkontaktierung 134 kann mit einem dritten elektrisch leitfähigen Material gefüllt werden. Das dritte elektrisch leitfähige Material kann mindestens eines aus der nachfolgenden Gruppe von Materialien aufweisen: Kupfer, Aluminium, Wolfram, Kobalt, Silber, Titan, Tantal oder eine Legierung der genannten Metalle.

In **Fig.1D** können mehrere zusätzliche Durchkontaktierungen 136, 138, 142 gebildet werden in der Bauelementanordnung 140.

Die mehreren zusätzlichen Durchkontaktierungen 136, 138, 142 können gebildet werden mittels verschiedener herkömmlicher Verfahren. Die mehreren zusätzlichen Durchkontaktierungen 136, 138, 142 können gebildet werden mittels demselben oder einem anderen herkömmlichen Verfahren wie das herkömmliche Verfahren, welches verwendet werden kann zum Bilden der mindestens einen Durchkontaktierung 134.

Im Anschluss kann ein Füllen der mehreren zusätzlichen Durchkontaktierungen 136, 138, 142 mittels verschiedener herkömmlicher Verfahren durchgeführt werden um eine Kontaktmetallisierung bereitzustellen. Die mehreren zusätzlichen Durchkontaktierungen 136, 138, 142 können mit dem dritten elektrisch leitfähigen Material gefüllt werden. Das dritte elektrisch leitfähige Material kann dasselbe oder ein anderes drittes elektrisch leitfähiges Material aufweisen wie das dritte elektrisch leitfähige Material der mindestens einen Durchkontaktierung 134.

Die mehreren zusätzlichen Durchkontaktierungen 136, 138, 142 können sich mindestens zwischen dem Träger 102 und der zweiten Metallisierungsschicht 128 erstrecken. Die mehreren zusätzlichen Durchkontaktierungen 136, 138, 142 können sich mindestens zwischen dem Träger 102 und der ersten Metallisierungsschicht 116 erstrecken. Die mehreren zusätzlichen Durchkontaktierungen 136, 138, 142 können sich mindestens zwischen der ersten Metallisierungsschicht 116 und der zweiten Metallisierungsschicht 128 erstrecken.

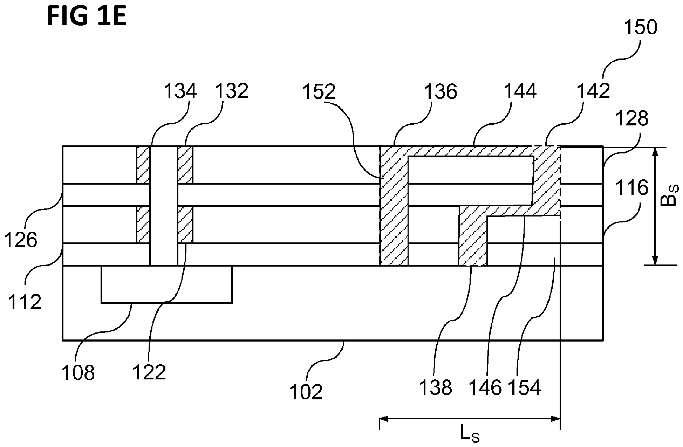

**Fig.1E** zeigt die Bauelementanordnung 150, wobei die Bauelementanordnung 150 aufweist: den Träger 102, z.B. ein Substrat, z.B. ein Halbleitersubstrat; das mindestens eine elektronische Bauelement 108, gebildet in dem Träger 102; die erste Metallisierungsschicht 116, wobei die erste Metallisierungsschicht 116 die erste metallische Kopplungsstruktur 122 aufweisen kann, welche mit dem mindestens einen elektronischen Bauelement 108 elektrisch leitend gekoppelt werden kann; die zweite Metallisierungsschicht 128, gebildet über der ersten Metallisierungsschicht 116, wobei die zweite Metallisierungsschicht 128 die zweite metallische Kopplungsstruktur 132 aufweisen kann und wobei die erste metallische Kopplungsstruktur 122 mit der zweiten metallischen Kopplungsstruktur 132 mittels der mindestens einen Durchkontaktierung 134 elektrisch leitend verbunden werden kann; und die mehreren zusätzlichen Durchkontaktierungen 136, 138, 142.

Die erste Metallisierungsschicht 116 und/oder die zweite Metallisierungsschicht 128 können das erste elektrisch leitfähige Material aufweisen. Das erste elektrisch leitfähige Material kann dasselbe oder ein anderes erstes elektrisch leitfähiges Material aufweisen wie das erste elektrisch leitfähige Material der ersten Metallisierungsschicht 116 und/oder der zweiten Metallisierungsschicht 128.

Die erste metallische Kopplungsstruktur 122 und/oder die zweite metallische Kopplungsstruktur 132 können das zweite elektrisch leitfähige Material aufweisen. Das zweite elektrisch leitfähige Material kann dasselbe oder ein anderes zweites elektrisch leitfähiges Material aufweisen wie das zweite elektrisch leitfähige Material der ersten metallischen Kopplungsstruktur 122 und/oder der zweiten metallischen Kopplungsstruktur 132. Die erste metallische Kopplungsstruktur 122 und/oder die zweite metallische Kopplungsstruktur 132 können somit Leiterbahnen aufweisen, die mittels eines Dielektrikums voneinander elektrisch isoliert sein können.

In Fig.lE können die mehreren zusätzlichen Durchkontaktierungen 136, 138, 142 elektrisch leitend gekoppelt werden mittels einer Mehrzahl von Leitungsstrukturen 144, 146, derart, dass sie eine Spule 152 bilden, wobei die Spule 152 einen Spulenbereich 154 aufweist, der in einem Winkel zu der Hauptprozessierungsebene des Trägers 102, z.B. der Trägeroberseite 104 des Trägers 102 liegen kann.

Die Mehrzahl von Leitungsstrukturen 144, 146 könnenmindestens in der ersten Metallisierungsschicht 116 und/oder der zweiten Metallisierungsschicht 128 verlaufen, wobei die Mehrzahl von Leitungsstrukturen 144, 146 ein viertes elektrisch leitfähiges Material 156 aufweisen können, das vierte elektrisch leitfähige Material 156 aufweisend mindestens eines aus der nachfolgenden Gruppe von Materialien: Kupfer (Cu), Aluminium (Al), Platin (Pt),
Gold (Au), Silber (Ag), Palladium (Pd), Nickel (Ni) oder eine Legierung der genannten Metalle. Das vierte elektrisch leitfähige Material 156 kann gebildet werden mittels verschiedener herkömmlicher Verfahren, beispielsweise mittels thermischen Verdampfens, chemischer Gasphasenabscheidung, Elektronenstrahlverdampfung, Kathodenzerstäubung (Sputtern), z.B. Gleichstrom-Kathodenzerstäubung, z.B. Bias-Kathodenzerstäubung, Einlegetechnik, Damaszenertechnik.

Die Spule 152 (Spule als ein passives induktives elektronisches Bauelement, welches eine definierte Induktivität und Güte aufweist) kann den Spulenbereich 154 aufweisen, wobei der Spulenbereich als ein Bereich eines Metallstapels, aufweisend z.B. die erste Metallisierungsschicht 116 und die zweite Metallisierungsschicht 128, verstanden werden kann, der die für die Bildung der Spule 152 in dem Metallstapel benötigte Fläche, aufweisend eine Länge, eine Breite, sowie eine Tiefe definieren kann. Der Spulenbereich 154 kann derart gebildet werden, dass er in einem Winkel zu der Hauptprozessierungsebene des Trägers 102 liegen kann.. Der Winkel kann beispielsweise in einem Bereich von größer als 0° bis zu 90° zu der Hauptprozessierungsebene des Trägers 102 liegen, z.B. in einem Bereich von größer als 20° bis zu 90°, z.B. in einem Bereich von größer als 40° bis zu 90°, z.B. in einem Bereich von größer als 60° bis zu 90°, z.B. in einem Bereich von größer als 80° bis zu 90°, z.B. in einem Bereich von größer als 85° bis zu 90°, z.B. von ungefähr 90°. Gemäß einem Ausführungsbeispiel kann der Winkel zwischen 0° und 85° liegen.

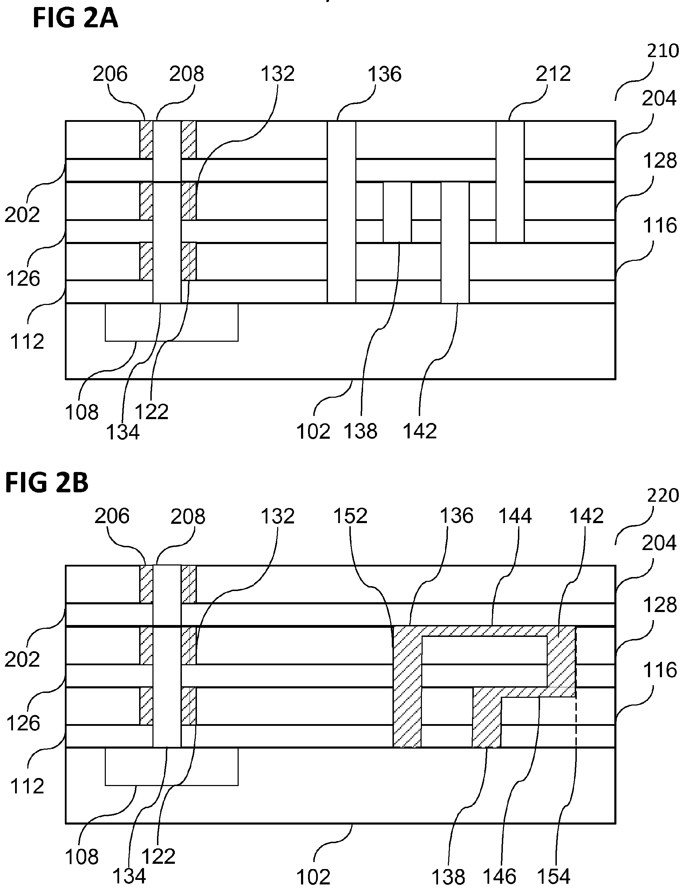

**Fig.2A bis Fig.2C** zeigen eine Bauelementanordnung gemäß einem Beispiel.

In den **Fig.2A bis Fig.2C** bezeichnen gleiche Bezugszeichen die gleichen Teile und/oder die gleichen Merkmale, wie sie oben in Bezug auf die **Fig.1A bis Fig.1E** beschrieben wurden. Im Folgenden werden im Wesentlichen nur noch die Unterschiede der Bauelementanordnung, wie sie in den Fig.2A bis Fig.2C dargestellt ist, zu der Bauelementanordnung, wie sie in den Fig.1A bis Fig.1E dargestellt ist, erläutert. Hinsichtlich der anderen Merkmale wird auf die obigen Beispiele unter Fig.1A bis Fig.1E verwiesen.

In einer Bauelementanordnung 210 (siehe **Fig.2A****)** kann eine dritte dielektrische Zwischenschicht 202 über der zweiten Metallisierungsschicht 128 gebildet werden. Die dritte dielektrische Zwischenschicht 202 kann das dielektrische Material aufweisen. Das dielektrische Material dasselbe oder ein anderes dielektrisches Material aufweisen wie das dielektrische Material der ersten dielektrischen Zwischenschicht 112 und/oder der zweiten dielektrischen Zwischenschicht 128.

Über der dritten dielektrischen Zwischenschicht 202 kann, in 210 (siehe Fig.2A), eine dritte Metallisierungsschicht 204 gebildet werden, wobei die dritte Metallisierungsschicht 204 das erste elektrisch leitfähige Material aufweisen kann. Das erste elektrisch leitfähige Material kann dasselbe oder ein anderes erstes elektrisch leitfähiges Material aufweisen wie das erste elektrisch leitfähige Material der ersten Metallisierungsschicht 116 und/oder der zweiten Metallisierungsschicht 128.

Die dritte Metallisierungsschicht 204 kann eine dritte metallische Kopplungsstruktur 206 aufweisen. Die dritte metallische Kopplungsstruktur 206 kann das zweite elektrisch leitfähige Material aufweisen. Das zweite elektrisch leitfähige Material kann dasselbe oder ein anderes zweites elektrisch leitfähiges Material aufweisen wie das zweite elektrisch leitfähige Material der ersten metallischen Kopplungsstruktur 122 und/oder der zweiten metallischen Kopplungsstruktur 132. Die dritte metallische Kopplungsstruktur 206 kann somit Leiterbahnen aufweisen, die mittels eines Dielektrikums voneinander elektrisch isoliert sein können. Die dritte metallische Kopplungsstruktur 206 kann mittels mindestens einer Durchkontaktierung 208 mit der zweiten metallischen Kopplungsstruktur 132 elektrisch leitend gekoppelt werden.

In Fig.2A können, gemäß einer Ausgestaltung, mehrere zusätzliche Durchkontaktierungen 136, 138, 142, 212 gebildet werden in der Bauelementanordnung 210.

Die mindestens eine Durchkontaktierung 208 und/oder die mehreren zusätzlichen Durchkontaktierungen 136, 138, 142, 212 können gebildet werden mittels verschiedener herkömmlicher Verfahren. Die mindestens eine Durchkontaktierung 208 und/oder die mehreren zusätzlichen Durchkontaktierungen 136, 138, 142, 212 können gebildet werden mittels demselben oder einem anderen herkömmlichen Verfahren wie das herkömmliche Verfahren, welches verwendet werden kann zum Bilden der mindestens einen Durchkontaktierung 134 und/oder der mehreren zusätzlichen Durchkontaktierungen 136, 142.

Im Anschluss kann ein Füllen der mindestens einen Durchkontaktierung 208 und/oder der mehreren zusätzlichen Durchkontaktierungen 136, 138, 142, 212 mittels verschiedener herkömmlicher Verfahren durchgeführt werden. Die mindestens eine Durchkontaktierung 208 und/oder die mehreren zusätzlichen Durchkontaktierungen 136, 138, 142, 212 können mit dem dritten elektrisch leitfähigen Material gefüllt werden. Das dritte elektrisch leitfähige Material kann dasselbe oder ein anderes drittes elektrisch leitfähiges Material aufweisen wie das dritte elektrisch leitfähige Material der mindestens einen Durchkontaktierung 134 und/oder der mehreren zusätzlichen Durchkontaktierungen 136, 138, 142.

Die mindestens eine Durchkontaktierung 208 kann sich mindestens zwischen der zweiten Metallisierungsschicht 128 und der dritten Metallisierungsschicht 204 erstrecken.

Die mehreren zusätzlichen Durchkontaktierungen 136, 138, 142, 212 können sich mindestens zwischen dem Träger 102 und der dritten Metallisierungsschicht 204 erstrecken. Die mehreren zusätzlichen Durchkontaktierungen 136, 138, 142, 212 können sich mindestens zwischen dem Träger 102 und der dritten Metallisierungsschicht 204 erstrecken. Die mehreren zusätzlichen Durchkontaktierungen 136, 138, 142, 212 können sich mindestens zwischen dem Träger 102 und der zweiten Metallisierungsschicht 128 erstrecken. Die mehreren zusätzlichen Durchkontaktierungen 136, 138, 142, 212 können sich mindestens zwischen dem Träger 102 und der ersten Metallisierungsschicht 116 erstrecken. Die mehreren zusätzlichen Durchkontaktierungen 136, 138, 142, 212 können sich mindestens zwischen der ersten Metallisierungsschicht 116 und der dritten Metallisierungsschicht 204 erstrecken. Die mehreren zusätzlichen Durchkontaktierungen 136, 138, 142, 212 können sich mindestens zwischen der ersten Metallisierungsschicht 116 und der zweiten Metallisierungsschicht 128 erstrecken. Die mehreren zusätzlichen Durchkontaktierungen 136, 138, 142, 212 können sich mindestens zwischen der zweiten Metallisierungsschicht 128 und der dritten Metallisierungsschicht 204 erstrecken.

In 220 (siehe **Fig.2B****)** kann eine Bauelementanordnung 220 ferner eine Mehrzahl von Leitungsstrukturen 144, 146 aufweisen. Die Mehrzahl von Leitungsstrukturen 144, 146 kann das vierte elektrisch leitfähige Material 156 aufweisen, wobei das vierte elektrisch leitfähige Material 156 mindestens eines aus der nachfolgenden Gruppe von Materialien aufweisen kann: Kupfer (Cu), Aluminium (Al), Platin (Pt), Gold (Au), Silber (Ag), Palladium (Pd), Nickel (Ni) oder eine Legierung der genannten Metalle. Das vierte elektrisch leitfähige Material 156 kann gebildet werden mittels verschiedener herkömmlicher Verfahren, beispielsweise mittels thermischen Verdampfens, chemischer Gasphasenabscheidung, Elektronenstrahlverdampfung, Kathodenzerstäubung (Sputtern), z.B. Gleichstrom-Kathodenzerstäubung, z.B. Bias-Kathodenzerstäubung, Einlegetechnik, Damaszenertechnik.

In 220 können die mehreren zusätzlichen Durchkontaktierungen 136, 138, 142 elektrisch leitend gekoppelt werden mittels der Mehrzahl von Leitungsstrukturen 144, 146, derart, dass sie eine Spule 152 bilden, die Spule 152 aufweisend einen Spulenbereich 154, welcher in einem Winkel zu der Hauptprozessierungsebene des Trägers 102, z.B. der Trägeroberseite 104 des Trägers 102 liegen kann. Ferner kann die Mehrzahl von Leitungsstrukturen 144, 146 mindestens in der ersten Metallisierungsschicht 116 und/oder der zweiten Metallisierungsschicht 128 verlaufen. Die in 220 gebildete Spule 152 kann mindestens eine Spulenwindung aufweisen, wobei die mindestens eine Spulenwindung den Spulenbereich 154 definiert.

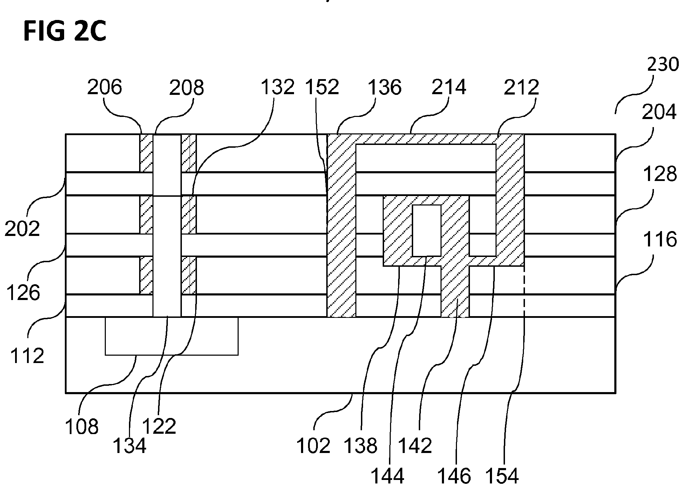

**Fig.2C** zeigt eine Bauelementanordnung 230, wobei die Bauelementanordnung 230 ferner die Spule 152 aufweist, wobei die Spule 152 ferner mehrere Spulenwindungen aufweisen kann.

In 230 (siehe Fig.2C) können die mehreren zusätzlichen Durchkontaktierungen 136, 138, 142, 212 elektrisch leitend gekoppelt werden mittels einer Mehrzahl von Leitungsstrukturen 144, 146, 214, derart, dass sie eine Spule 152 bilden, welche den Spulenbereich 154 aufweist.

Die Mehrzahl von Leitungsstrukturen 144, 146, 214 können das vierte elektrisch leitfähige Material 156 aufweisen. Das vierte elektrisch leitfähige Material 156 kann dasselbe oder ein anderes viertes elektrisch leitfähiges Material aufweisen wie das vierte elektrisch leitfähige Material der Mehrzahl von Leitungsstrukturen 144, 146.

In 230 können die mehreren zusätzliche Durchkontaktierungen 136, 138, 142, 212 gebildet werden, derart, dass sich die mehreren zusätzlichen Durchkontaktierungen 136, 138, 142, 212 derart mindestens zwischen der ersten Metallisierungsschicht 116 und der zweiten Metallisierungsschicht 128 erstrecken, dass der Spulenbereich 154 in einem Winkel zu der Hauptprozessierungsebene des Trägers 102, z.B. der Trägeroberseite 104 des Trägers 102, liegt.

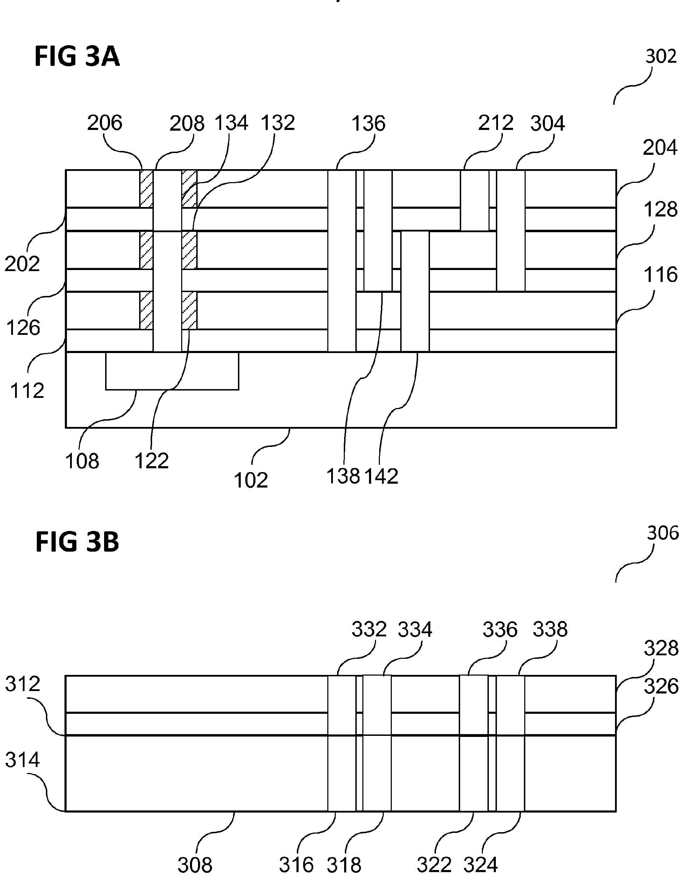

**Fig.3A bis Fig.3F** zeigen eine Bauelementanordnung gemäß einem Beispiel.

In den **Fig.3A bis Fig.3F** bezeichnen gleiche Bezugszeichen die gleichen Teile und/oder die gleichen Merkmale, wie sie oben in Bezug auf die Fig.1A bis Fig.1E und/oder die Fig.2A bis Fig.2C beschrieben wurden. Im Folgenden werden im Wesentlichen nur noch die Unterschiede der Bauelementanordnung, wie sie in den Fig.3A bis Fig.3F dargestellt ist, zu der Bauelementanordnung, wie sie in den Fig.1A bis Fig.1E und/oder den Fig.2A bis Fig.2C dargestellt ist, erläutert. Hinsichtlich der anderen Merkmale wird auf die obigen Beispiele unter den Fig.1A bis Fig.1E und/oder den Fig.2A bis Fig.2C verwiesen.

In **Fig.3A** (in 310) können mehrere zusätzliche Durchkontaktierungen 136, 138, 142, 212, 304 gebildet werden mittels verschiedener herkömmlicher Verfahren. Die mehreren zusätzlichen Durchkontaktierungen 136, 138, 142, 212, 304 können gebildet werden mittels demselben oder einem anderen herkömmlichen Verfahren wie das herkömmliche Verfahren, welches verwendet werden kann zum Bilden der mindestens einen Durchkontaktierung 134 und/oder der mindestens einen Durchkontaktierung 208 und/oder der mehreren zusätzlichen Durchkontaktierungen 136, 142, 212. Im Anschluss kann ein Füllen der mehreren zusätzlichen Durchkontaktierungen 136, 138, 142, 212, 304 mittels verschiedener herkömmlicher Verfahren durchgeführt werden. Die mehreren zusätzlichen Durchkontaktierungen 136, 138, 142, 212, 304 können mit dem dritten elektrisch leitfähigen Material gefüllt werden. Das dritte elektrisch leitfähige Material kann dasselbe oder ein anderes drittes elektrisch leitfähiges Material aufweisen wie das dritte elektrisch leitfähige Material der mindestens einen Durchkontaktierung 134 und/oder der mindestens einen Durchkontaktierung 208 und/oder der mehreren zusätzlichen Durchkontaktierungen 136, 138, 142, 212.

Die mehreren zusätzlichen Durchkontaktierungen 136, 138, 142, 212, 304 können sich mindestens zwischen dem Träger 102 und der dritten Metallisierungsschicht 204 erstrecken. Die mehreren zusätzlichen
Durchkontaktierungen 136, 138, 142, 212, 304 können sich mindestens zwischen der ersten Metallisierungsschicht 116 und der dritten Metallisierungsschicht 204 erstrecken. Die mehreren zusätzlichen Durchkontaktierungen 136, 138, 142, 212, 304 können sich mindestens zwischen dem Träger 102 und der zweiten Metallisierungsschicht 128 erstrecken. Die mehreren zusätzlichen Durchkontaktierungen 136, 138, 142, 212, 304 können sich mindestens zwischen dem Träger 102 und der ersten Metallisierungsschicht 116 erstrecken. Die mehreren zusätzlichen Durchkontaktierungen 136, 138, 142, 212, 304 können sich mindestens zwischen der ersten Metallisierungsschicht 116 und der zweiten Metallisierungsschicht 128 erstrecken. Die mehreren zusätzlichen Durchkontaktierungen 136, 138, 142, 212, 304 können sich mindestens zwischen der zweiten Metallisierungsschicht 128 und der dritten Metallisierungsschicht 204 erstrecken.

In **Fig.3B** ist eine zweite Bauelementanordnung 306 dargestellt, welche mindestens einen zusätzlichen Träger 308 aufweisen kann. Es ist darauf hinzuweisen, dass auch mehr als ein zusätzlicher Träger in verschiedenen Ausführungsbeispielen vorgesehen sein können, beispielsweise 2, 3, 4, 5, 6, 7 oder sogar mehr.

Der zusätzliche Träger 308, z.B. ein Substrat, z.B. ein Halbleitersubstrat, kann eine Trägeroberseite 312 und eine Trägerunterseite 314 aufweisen, welche gegenüberliegend angeordnet sein, und wobei die Trägeroberseite 312 die Hauptprozessierungsebene des zusätzlichen Trägers 308 bildet.

Der zusätzliche Träger 308 kann mindestens ein Halbleitermaterial aufweisen. Der zusätzliche Träger 308 kann dasselbe oder ein anderes Halbleitermaterial aufweisen wie der Träger 102.

In dem zusätzlichen Träger 308 kann eine Mehrzahl von Silizium-Durchkontaktierungen 316, 318, 322, 324 (Through-Silicon-Via, TSV), zur Realisierung elektrischer Verbindungen (Kopplungen) zwischen einer Mehrzahl von Bauelementanordnungen (Chips) bei der 3D- Integration, gebildet werden mittels verschiedener herkömmlicher Verfahren. In einer Ausgestaltung kann die Mehrzahl von Silizium-Durchkontaktierungen 316, 318, 322, 324 gebildet werden mittels eines mechanischen Bohrprozesses, alternativ mittels eines oder mehrerer Lithographieprozesse, welchen einen oder mehrere Belichtungsprozesse und einen oder mehrere Ätzprozesse enthalten können. In einer anderen Ausgestaltung kann die Mehrzahl von Silizium-Durchkontaktierungen 316, 318, 322, 324 gebildet werden mittels Laserablation. In einer weiteren Ausgestaltung kann die Mehrzahl von Silizium-Durchkontaktierungen 316, 318, 322, 324 gebildet werden mittels eines Ätzprozesses, z.B. mittels eines nasschemischen Ätzprozesses, z.B. mittels eines Trockenätzprozesses wie beispielsweise reaktivem Ionentiefenätzen (deep reactive ion etching, DRIE). Anschließend kann ein Füllen der Mehrzahl von Silizium-Durchkontaktierungen 316, 318, 322, 324 mittels verschiedener herkömmlicher Verfahren durchgeführt werden. Die Mehrzahl von Silizium-Durchkontaktierungen 316, 318, 322, 324 kann mit dem dritten elektrisch leitfähigen Material gefüllt werden. Das dritte elektrisch leitfähige Material kann dasselbe oder ein anderes drittes elektrisch leitfähiges Material aufweisen wie das dritte elektrisch leitfähige Material der mindestens einen Durchkontaktierung 134 und/oder der mindestens einen Durchkontaktierung 208 und/oder der mehreren zusätzlichen Durchkontaktierungen 136, 138, 142, 212, 304.

Über dem zusätzlichen Träger 308 kann eine erste zusätzliche dielektrische Zwischenschicht 326 gebildet werden. Die erste zusätzliche Zwischenschicht 326 kann das dielektrische Material aufweisen. Das dielektrische Material kann dasselbe oder ein anderes dielektrisches Material aufweisen wie das dielektrische Material der ersten dielektrischen Zwischenschicht 112.

Über die erste zusätzliche dielektrische Zwischenschicht 326 kann gemäß einer Ausgestaltung, eine erste zusätzliche Metallisierungsschicht 328 gebildet werden, wobei die erste zusätzliche Metallisierungsschicht 328 das erste elektrisch leitfähige Material aufweisen kann. Das erste elektrisch leitfähige Material kann dasselbe oder ein anderes erstes elektrisch leitfähiges Material aufweisen wie das erste elektrisch leitfähige Material der ersten Metallisierungsschicht 116 und/oder der zweiten Metallisierungsschicht 128 und/oder der dritten Metallisierungsschicht 204.

Ferner kann die zweite Bauelementanordnung 306, wie gezeigt in Fig.3B, gemäß einer Ausgestaltung, mindestens mehrere zusätzliche Durchkontaktierungen 332, 334, 336, 338 aufweisen, welche gebildet werden können mittels verschiedener herkömmlicher Verfahren. Die mehreren zusätzlichen Durchkontaktierungen 332, 334, 336, 338 können gebildet werden mittels demselben oder einem anderen herkömmlichen Verfahren wie das herkömmliche Verfahren, welches verwendet werden kann zum Bilden der mindestens einen Durchkontaktierung 134 und/oder der mindestens einen Durchkontaktierung 208 und/oder der mehreren zusätzlichen Durchkontaktierungen 136, 142, 212, 304. Im Anschluss kann ein Füllen (filling) der mindestens mehreren zusätzlichen Durchkontaktierungen 332, 334, 336, 338 mittels verschiedener herkömmlicher Verfahren durchgeführt werden um eine Kontaktmetallisierung bereitzustellen. Die mehreren zusätzlichen Durchkontaktierungen 332, 334, 336, 338 können mit dem dritten elektrisch leitfähigen Material gefüllt werden. Das dritte elektrisch leitfähige Material kann dasselbe oder ein anderes drittes elektrisch leitfähiges Material aufweisen wie das dritte elektrisch leitfähige Material der mindestens einen Durchkontaktierung 134 und/oder der mindestens einen Durchkontaktierung 208 und/oder der mehreren zusätzlichen Durchkontaktierungen 136, 138, 142, 212, 304 und/oder der mehreren Silizium-Durchkontaktierungen 316, 318, 322, 324.

Die mindestens zwei zusätzlichen Durchkontaktierungen 332, 334, 336, 338 können sich mindestens zwischen dem zusätzlichen Träger 308 und der ersten zusätzlichen Metallisierungsschicht 328 erstrecken.

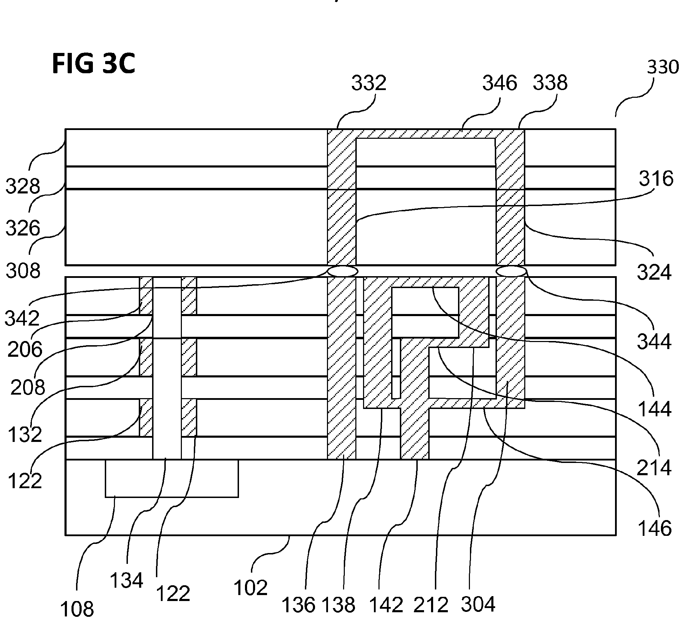

In **Fig.3C** (in 330) kann, gemäß einer Ausgestaltung, die zweite Bauelementanordnung 306, wie gezeigt in Fig.3B und oben beschrieben, angeordnet werden über und elektrisch leitend gekoppelt werden mit der ersten Bauelementanordnung 302, wie gezeigt in Fig.3A und oben beschrieben, mittels einer Mehrzahl von Chipverbindungen 342, 344 mit Hilfe der mehreren zusätzlichen Durchkontaktierungen 136, 304 und der Mehrzahl von Silizium-Durchkontaktierungen 316, 324, unter Verwendung verschiedener herkömmlicher Verfahren, beispielsweise Flip-Chip-Montage.

Gemäß einer Ausgestaltung kann die Mehrzahl von Chipverbindungen 342, 344 gebildet werden mit Hilfe verschiedener herkömmlicher Verfahren. In einer Ausführungsform kann die Mehrzahl von Chipverbindungen 342, 344 gebildet werden mittels Lötens, z.B. unter Verwendung eines Lotes, beispielsweise unter Verwendung eines elektrisch leitfähigen Lotes, z.B. eines Weichlotes, z.B. eines Diffusionslotes. In einer anderen Ausgestaltung kann die Mehrzahl von Chipverbindungen 342, 344 gebildet werden mittels Klebens, beispielsweise unter Verwendung eines Klebers, z.B. eines elektrisch leitfähigen Klebers, z.B. eines elektrisch isotrop leitfähigen Klebers, z.B. eines elektrisch anisotrop leitfähigen Klebers.

Gemäß einer Ausgestaltung kann die erste zusätzliche Metallisierungsschicht 328 derart mit den mehreren zusätzlichen Durchkontaktierungen 136, 304 elektrisch leitend gekoppelt werden, dass zumindest ein Teil der ersten zusätzlichen Metallisierungsschicht 328 einen Teil der Spule 152 bildet. In einem Beispiel kann die erste zusätzliche Metallisierungsschicht 328 derart elektrisch leitend gekoppelt werden mit den mehreren zusätzlichen Durchkontaktierungen 136, 304 unter Verwendung der Mehrzahl von Chipverbindungen 342, 344 und einer zusätzlichen Leitungsstruktur 346, dass zumindest ein Teil der ersten zusätzlichen Metallisierungsschicht 328 einen Teil der Spule 152 bildet. In einem Beispiel kann die zusätzliche Leitungsstruktur 346 das vierte elektrisch leitfähige Material 156 aufweisen, das vierte elektrisch leitfähige Material 156 kann dasselbe oder ein anderes viertes elektrisch leitfähiges Material aufweisen wie das vierte elektrisch leitfähige Material der Mehrzahl von Leitungsstrukturen 144, 146 und/oder der Mehrzahl von Leitungsstrukturen 146, 212.

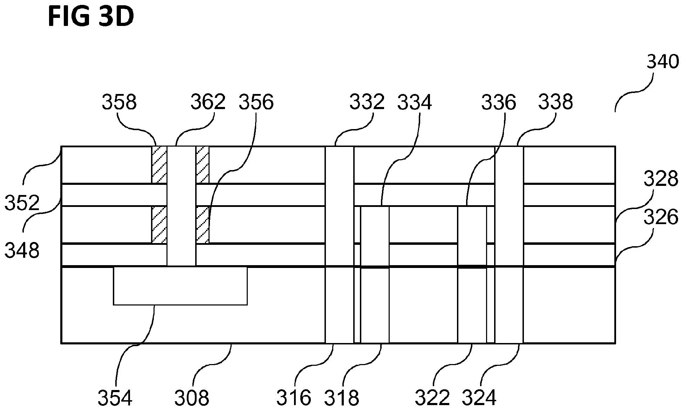

Gemäß einer Ausgestaltung kann in dem zusätzlichen Träger 308 der zweiten Bauelementanordnung 306, wie gezeigt in **Fig.3D** in der Bauelementanordnung 340, mindestens ein zusätzliches elektronisches Bauelement 354, beispielsweise ein aktives elektronisches Bauelement, gebildet sein kann. Das mindestens eine zusätzliche elektronische Bauelement 354 kann mindestens eines der folgenden elektronischen Bauelemente aufweisen oder als solches eingerichtet sein: Widerstand, Diode, Transistor, Kondensator, Spule, Thyristor, Solarzelle, elektrooptisches Bauelement, mikromechanisches Bauelement.

Gemäß einer Ausgestaltung kann in Fig.3D (siehe 340) eine zweite zusätzliche dielektrische Zwischenschicht 348 gebildet werden über der ersten zusätzlichen Metallisierungsschicht 328. Die zweite zusätzliche dielektrische Zwischenschicht 348 kann ein oder mehr oder alle Merkmale aufweisen, wie bereits in Bezug auf die erste dielektrische Zwischenschicht 112 und/oder die zweite dielektrische Zwischenschicht 123 und/oder die dritte dielektrische Zwischenschicht 202 und/oder die erste zusätzliche dielektrische Zwischenschicht 326 beschrieben.

Gemäß einer Ausgestaltung kann anschließend über der zweiten zusätzlichen dielektrischen Zwischenschicht 348 eine zweite zusätzliche Metallisierungsschicht 352 gebildet werden. Die zweite zusätzliche Metallisierungsschicht kann ein oder mehr oder alle Merkmale aufweisen, wie bereits in Bezug auf die erste Metallisierungsschicht 116 und/oder die zweite Metallisierungsschicht 128 und/oder die dritte Metallisierungsschicht 204 und/oder die erste zusätzliche Metallisierungsschicht 328 beschrieben.

Gemäß einer Ausgestaltung kann die erste zusätzliche Metallisierungsschicht 328 eine erste zusätzliche metallische Kopplungsstruktur 356 aufweisen, die mit dem mindestens einen zusätzlichen elektronischen Bauelement 354, elektrisch leitend gekoppelt ist, und die zweite zusätzliche Metallisierungsschicht 352 kann eine zweite zusätzliche metallische Kopplungsstruktur 358 aufweisen. Die erste zusätzliche metallische Kopplungsstruktur 356 und/oder die zweite zusätzliche metallische Kopplungsstruktur 358 können ein oder mehr oder alle Merkmale aufweisen, wie bereits in Bezug auf die erste metallische Kopplungsstruktur 122 und/oder die zweite metallische Kopplungsstruktur 132 und/oder die dritte metallische Kopplungsstruktur 206 beschrieben.

In noch einer Ausgestaltung weisen die erste zusätzliche metallische Kopplungsstruktur 356 und/oder die zweite zusätzliche metallische Kopplungsstruktur 358 eine Mehrzahl von Metallleiterbahnen auf. Die erste zusätzliche metallische Kopplungsstruktur 356 und/oder die zweite zusätzliche metallische Kopplungsstruktur 358 können somit Leiterbahnen aufweisen, die mittels eines Dielektrikums voneinander elektrisch isoliert sein können.

Gemäß eine Ausgestaltung kann die erste zusätzliche Metallisierungsschicht 328, welche die erste zusätzliche metallische Kopplungsstruktur 352 aufweist, mit Hilfe mindestens einer Durchkontaktierung 362 elektrisch leitend gekoppelt werden mit der zweiten zusätzlichen Metallisierungsschicht 352, welche die zweite zusätzliche metallische Kopplungsstruktur 358 aufweist, wobei sich die mindestens eine Durchkontaktierung 362 zwischen der ersten zusätzlichen Metallisierungsschicht 328 und der zweiten zusätzlichen Metallisierungsschicht 352 erstrecken kann. Die mindestens eine Durchkontaktierung 362 kann ein oder mehr oder alle Merkmale aufweisen, wie bereits in Bezug auf die mindestens eine Durchkontaktierung 134 und/oder die mindestens eine Durchkontaktierung 208 und/oder die mehreren zusätzlichen Durchkontaktierungen 136, 138, 142, 212, 304 und/oder die mehreren zusätzlichen Durchkontaktierungen 332, 334, 336, 338 beschrieben.

Ferner können sich, gemäß einer Ausgestaltung, die mehreren zusätzlichen Durchkontaktierungen 332, 334, 336, 338 zumindest zwischen der ersten zusätzlichen Metallisierungsschicht 328 und der zweiten zusätzlichen Metallisierungsschicht 352 und/oder zwischen dem zusätzlichen Träger 308 und der ersten zusätzlichen Metallisierungsschicht 328 und/oder zwischen dem zusätzlichen Träger 308 und der zweiten zusätzlichen Metallisierungsschicht 352 erstrecken.

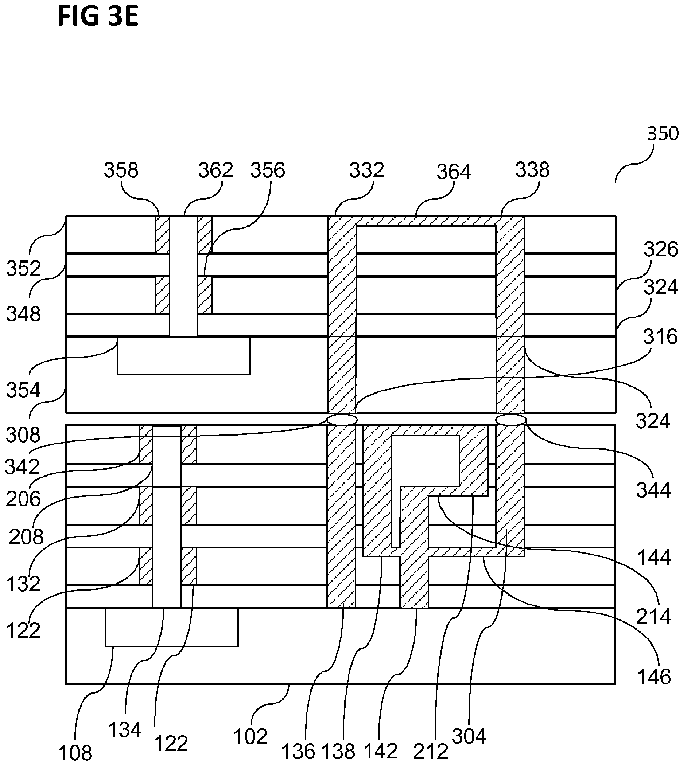

Gemäß einer Ausführungsform kann in **Fig.3E** die Bauelementanordnung 340, wie gezeigt in Fig.3D und oben beschrieben, angeordnet werden über und elektrisch leitend gekoppelt werden mit der ersten Bauelementanordnung 302, wie gezeigt in Fig.3A und oben beschrieben, mittels der Mehrzahl von Chipverbindungen 342, 344 mit Hilfe der mehreren zusätzlichen Durchkontaktierungen 136, 304 und der Mehrzahl von Silizium-Durchkontaktierungen 316, 324, unter Verwendung verschiedener herkömmlicher Verfahren, beispielsweise Flip-Chip-Montage.

Gemäß einer Ausgestaltung kann die Mehrzahl von Chipverbindungen 342, 344 gebildet werden mittels verschiedener herkömmlicher Verfahren, wie oben beschrieben in 330. In einer Ausgestaltung kann die Mehrzahl von Chipverbindungen 342, 344 gebildet werden mittels Lötens, z.B. unter Verwendung eines Lotes, beispielsweise unter Verwendung eines elektrisch leitfähigen Lotes, z.B. eines Weichlotes, z.B. eines Diffusionslotes. In einer anderen Ausgestaltung kann die Mehrzahl von Chipverbindungen 342, 344 gebildet werden mittels Klebens, beispielsweise unter Verwendung eines Klebers (auch bezeichnet als Klebstoff, Klebermittel, Klebe), z.B. eines elektrisch leitfähigen Klebers, z.B. eines elektrisch isotrop leitfähigen Klebers, z.B. eines elektrisch anisotrop leitfähigen Klebers.

Gemäß einer Ausgestaltung kann die zweite zusätzliche Metallisierungsschicht 352 derart mit den mehreren zusätzlichen Durchkontaktierungen 136, 304 elektrisch leitend gekoppelt werden, dass zumindest ein Teil der zweiten zusätzlichen Metallisierungsschicht 352 einen Teil der Spule bildet. In einem Beispiel kann die zweite zusätzliche Metallisierungsschicht 352 derart elektrisch leitend gekoppelt werden mittels der mehreren zusätzlichen Durchkontaktierungen 136, 304 unter Verwendung der Mehrzahl von Chipverbindungen 342, 344 und einer zusätzlichen Leitungsstruktur 364, dass zumindest ein Teil der zweiten zusätzlichen Metallisierungsschicht 352 einen Teil der Spule bildet. In einem Beispiel kann die zusätzliche Leitungsstruktur 364 ein oder mehr oder alle Merkmale aufweisen, wie bereits in Bezug auf die Leitungsstrukturen 144, 146 und/oder die Leitungsstruktur 214 und/oder die zusätzliche Leitungsstruktur 346 beschrieben.

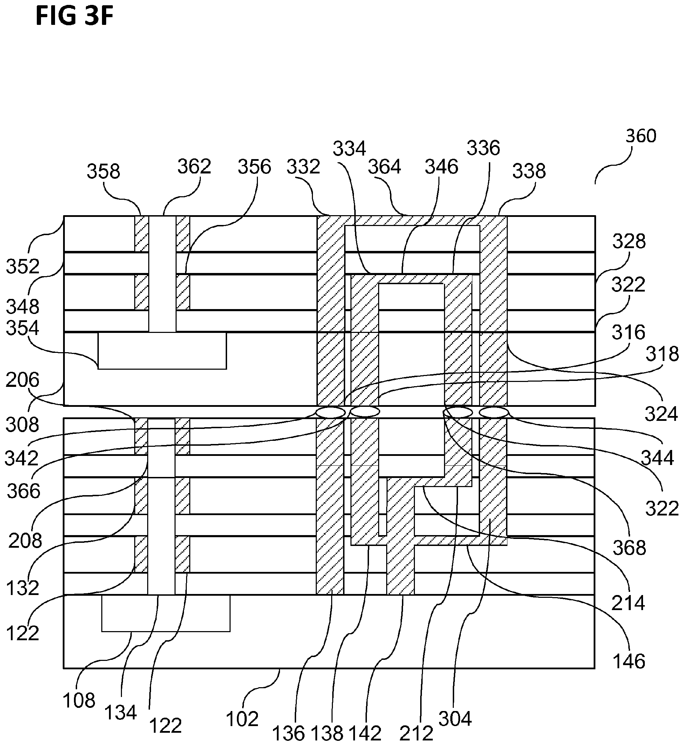

Gemäß einer Ausführungsform kann in **Fig.3F** (in 360) die Bauelementanordnung 340, wie gezeigt in Fig.3D und oben beschrieben, angeordnet werden über und elektrisch leitend gekoppelt mit der ersten Bauelementanordnung 302, wie oben beschrieben, mittels der Mehrzahl von Chipverbindungen 342, 344, 366, 368 mit Hilfe der mehreren zusätzlichen Durchkontaktierungen 332, 334, 336, 338 und der Mehrzahl von Silizium-Durchkontaktierungen 316, 318, 322, 324, unter Verwendung verschiedener herkömmlicher Verfahren, beispielsweise Flip-Chip-Montage.

In 360 kann die Bauelementanordnung 360 mehrere zusätzliche Durchkontaktierungen 332, 334, 336, 338 aufweisen. Die mehreren zusätzlichen Durchkontaktierungen 332, 334, 336, 338 können ein oder mehr oder alle Merkmale aufweisen, wie bereits in Bezug auf die mindestens eine Durchkontaktierung 134 und/oder die mindestens eine Durchkontaktierung 362 und/oder die mehreren zusätzlichen Durchkontaktierungen 136, 138, 142, 212, 304 beschrieben. Ferner können sich, gemäß einer Ausgestaltung, die mehreren zusätzlichen Durchkontaktierungen 332, 334, 336, 338 zumindest zwischen der ersten zusätzlichen Metallisierungsschicht 328 und der zweiten zusätzlichen Metallisierungsschicht 34 und/oder zwischen dem zusätzlichen Träger 308 und der ersten zusätzlichen Metallisierungsschicht 328 und/oder zwischen dem zusätzlichen Träger 308 und der zweiten zusätzlichen Metallisierungsschicht 352 erstrecken.

Gemäß einer Ausgestaltung können die erste zusätzliche Metallisierungsschicht 328 und/oder die zweite zusätzliche Metallisierungsschicht 352 derart mit den mehren zusätzlichen Durchkontaktierungen 136, 138, 142, 212, 304 elektrisch leitend gekoppelt werden, dass zumindest ein Teil der ersten zusätzlichen Metallisierungsschicht 328 und/oder zumindest ein Teil der zweiten zusätzlichen Metallisierungsschicht 352 einen Teil der Spule 152 bildet. In einem Beispiel kann die erste Metallisierungsschicht 328 und/oder die zweite zusätzliche Metallisierungsschicht 352 derart elektrisch leitend gekoppelt werden mittels der mehreren zusätzlichen Durchkontaktierungen 136, 138, 142, 212, 304 unter Verwendung der Mehrzahl von Chipverbindungen 342, 344, 366, 368 und zumindest den zusätzlichen Leitungsstrukturen 346, 364, dass zumindest ein Teil der ersten zusätzlichen Metallisierungsschicht 328 und/oder der zweiten zusätzlichen Metallisierungsschicht 352 einen Teil der Spule bilden.

Gemäß einer Ausgestaltung kann die Mehrzahl von Chipverbindungen 342, 344, 366, 368 gebildet werden mittels verschiedener herkömmlicher Verfahren, wie oben beschrieben in 330. In einer Ausgestaltung kann die Mehrzahl von Chipverbindungen 342, 344, 366, 368 gebildet werden mittels Löten, z.B. unter Verwendung eines Lotes, beispielsweise unter Verwendung eines elektrisch leitfähigen Lotes, z.B. eines Weichlotes, z.B. eines Diffusionslotes. In einer anderen Ausgestaltung kann die Mehrzahl von Chipverbindungen 336, 338, 366, 368 gebildet werden mittels Klebens, beispielsweise unter Verwendung eines Klebers, z.B. eines elektrisch leitfähigen Klebers, z.B. eines elektrisch isotrop leitfähigen Klebers, z.B. eines elektrisch anisotrop leitfähigen Klebers.

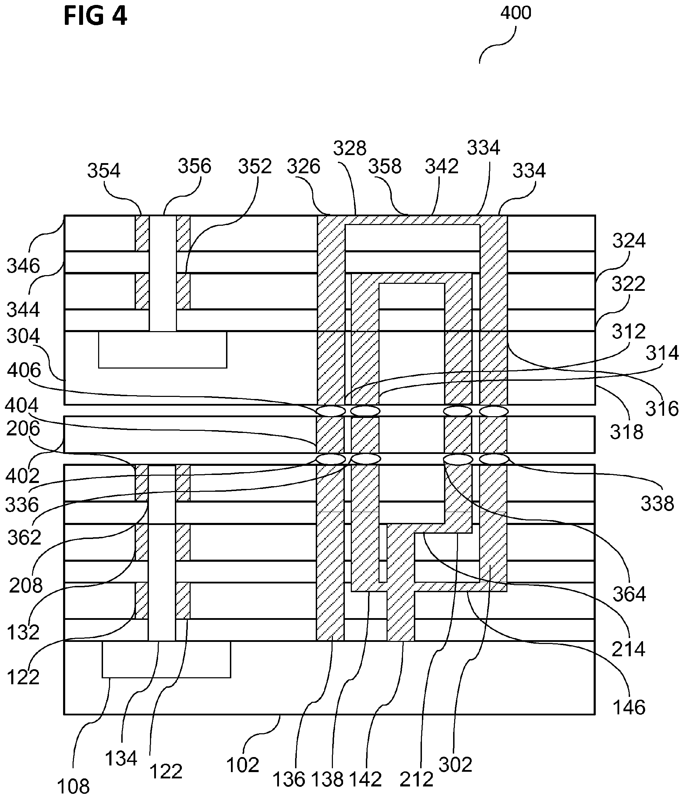

**Fig.4** zeigt eine Bauelementanordnung gemäß einer Ausführungsform.

In der **Fig.4** bezeichnen gleiche Bezugszeichen die gleichen Teile und/oder die gleichen Merkmale, wie sie oben in Bezug auf die **Fig.1A bis Fig.1E** und/oder die **Fig.2A bis Fig.2C** und/oder die **Fig.3A bis Fig.3F** beschrieben wurden. Im Folgenden werden im Wesentlichen nur noch die Unterschiede der Bauelementanordnung, wie sie in den Fig.3A bis Fig.3F dargestellt ist, zu der Bauelementanordnung, wie sie in den Fig.1A bis **Fig.1E** und/oder den Fig.2A bis Fig.2C und/oder den Fig.3A bis Fig.3F dargestellt ist, erläutert. Hinsichtlich der anderen Merkmale wird auf die obigen Beispiele unter Fig.1A bis Fig.1E und/oder Fig.2A bis Fig.2C und/oder Fig.3A bis Fig.3F verwiesen.

Gemäß einer Ausgestaltung kann die Bauelementanordnung 340, wie gezeigt in Fig.3D und oben beschrieben, angeordnet werden über der ersten Bauelementanordnung 302, wie gezeigt in Fig.3A und oben beschrieben, unter Verwendung eines Zwischenträgers 402, welcher eine Mehrzahl von Zwischenträger-Durchkontaktierungen 404 aufweist, sowie der Mehrzahl von Chipverbindungen 342, 344, 366, 368 und einer Mehrzahl von Chipverbindungen 406.

Gemäß einer Ausgestaltung kann ein Zwischenträger 402 (interposer) mindestens eines aus der nachfolgenden Gruppe an Materialien aufweisen: Silizium, Glas, einem elektrisch isolierenden Polymer. Der Zwischenträger 402 kann mit Hilfe verschiedener herkömmlicher Verfahren bereitgestellt werden, zum Beispiel mittels Silizium-Interposer-Technologie.

Der Zwischenträger 402 kann eine Dicke (Oberseite-zu-Unterseite) in einem Bereich von ungefähr 300 µm bis ungefähr 400 µm aufweisen, wobei jedoch die Dicke stark variieren kann und abhängig ist von der jeweils verwendeten Technologie.

In einer Ausgestaltung kann der Zwischenträger 402 eine Mehrzahl von Zwischenträger-Durchkontaktierungen 404 zur Realisierung einer elektrischen Verbindung (Kopplung) zwischen einer Mehrzahl von Chips bei der 3D-Integration, welche gebildet werden können mit Hilfe verschiedener herkömmlicher Verfahren, aufweisen.

In einer Ausgestaltung kann die Mehrzahl von Zwischenträger-Durchkontaktierungen 404 in dem Zwischenträger 402 gebildet werden mittels eines Bohrprozesses, z.B. mittels eines LaserBohrprozesses, z.B. mittels mechanischen Bohrens. In einer anderen Ausgestaltung kann die Mehrzahl von Zwischenträger-Durchkontaktierungen 404 in dem Zwischenträger 402 gebildet werden mittels eines Ätzprozesses, z.B. mittels eines nasschemischen Ätzprozesses, z.B. mittels eines Trockenätzprozesses, z.B. mittels Plasmaätzen. Im Anschluss kann ein Füllen (filling) der Mehrzahl von Zwischenträger-Durchkontaktierungen 404 mittels verschiedener herkömmlicher Verfahren durchgeführt werden. Die Mehrzahl von Zwischenträger-Durchkontaktierungen 404 kann mit dem dritten elektrisch leitfähigen Material gefüllt werden. Das dritte elektrisch leitfähige Material kann dasselbe oder ein anderes drittes elektrisch leitfähiges Material aufweisen wie das dritte elektrisch leitfähige Material der mindestens einen Durchkontaktierung 134 und/oder der mindestens einen Durchkontaktierung 208 und/oder der mehreren Durchkontaktierungen 136, 138, 142, 212, 304 und/oder der mehreren Silizium-Durchkontaktierungen 316, 318, 322, 324 und/oder der mehreren zusätzlichen Durchkontaktierungen 332, 334, 336, 338.

Die Bauelementanordnung 400 kann mehrere zusätzliche Durchkontaktierungen 332, 334, 336, 338 aufweisen. Die mehreren zusätzlichen Durchkontaktierungen 332, 334, 336, 338 können ein oder mehr oder alle Merkmale aufweisen, wie bereits in Bezug auf die mindestens eine Durchkontaktierung 134 und/oder die mindestens eine Durchkontaktierung 366 und/oder die mehreren zusätzlichen Durchkontaktierungen 136, 138, 142, 212, 304 beschrieben. Ferner können sich, gemäß einer Ausgestaltung, die mehreren zusätzlichen Durchkontaktierungen 332, 334, 336, 338 zumindest zwischen der ersten zusätzlichen Metallisierungsschicht 328 und der zweiten zusätzlichen Metallisierungsschicht 352 und/oder zwischen dem zusätzlichen Träger 308 und der ersten zusätzlichen Metallisierungsschicht 328 und/oder zwischen dem zusätzlichen Träger 308 und der zweiten zusätzlichen Metallisierungsschicht 352 erstrecken.

Gemäß einer Ausgestaltung können die erste zusätzliche Metallisierungsschicht 328 und/oder die zweite zusätzliche Metallisierungsschicht 352 derart mit den mehren zusätzlichen Durchkontaktierungen 136, 138, 142, 212, 304 elektrisch leitend gekoppelt werden, dass zumindest ein Teil der ersten zusätzlichen Metallisierungsschicht 328 und/oder zumindest ein Teil der zweiten zusätzlichen Metallisierungsschicht 352 einen Teil der Spule 152 bildet. In einem Beispiel kann die erste Metallisierungsschicht 328 und/oder die zweite zusätzliche Metallisierungsschicht 352 derart elektrisch leitend gekoppelt werden mittels der mehreren zusätzlichen Durchkontaktierungen 136, 138, 142, 212, 304 unter Verwendung der Mehrzahl von Chipverbindungen 342, 344, 366, 368, der Mehrzahl von Chipverbindungen 406 und dem Zwischenträger 402, welcher die Mehrzahl von Zwischenträger-Durchkontaktierungen 404 aufweist, und zumindest den zusätzlichen Leitungsstrukturen 346, 364, dass zumindest ein Teil der ersten zusätzlichen Metallisierungsschicht 328 und/oder der zweiten zusätzlichen Metallisierungsschicht 352 einen Teil der Spule bilden.

Gemäß einer Ausgestaltung kann die Mehrzahl von Chipverbindungen 342, 344, 366, 368 und/oder die Mehrzahl von Chipverbindungen 406 gebildet werden mittels verschiedener herkömmlicher Verfahren, wie oben beschrieben in 330. In einer Ausgestaltung kann die Mehrzahl von Chipverbindungen 342, 344 und/oder die Mehrzahl von Chipverbindungen 406 gebildet werden mittels Lötens, z.B. unter Verwendung eines Lotes, beispielsweise unter Verwendung eines elektrisch leitfähigen Lotes, z.B. eines Weichlotes, z.B. eines Diffusionslotes. In einer anderen Ausgestaltung kann die Mehrzahl von Chipverbindungen 342, 344, 366, 368 und/oder die Mehrzahl von Chipverbindungen 406 gebildet werden mittels Klebens, beispielsweise unter Verwendung eines Klebers, z.B. eines elektrisch leitfähigen Klebers, z.B. eines elektrisch isotrop leitfähigen Klebers, z.B. eines elektrisch anisotrop leitfähigen Klebers.

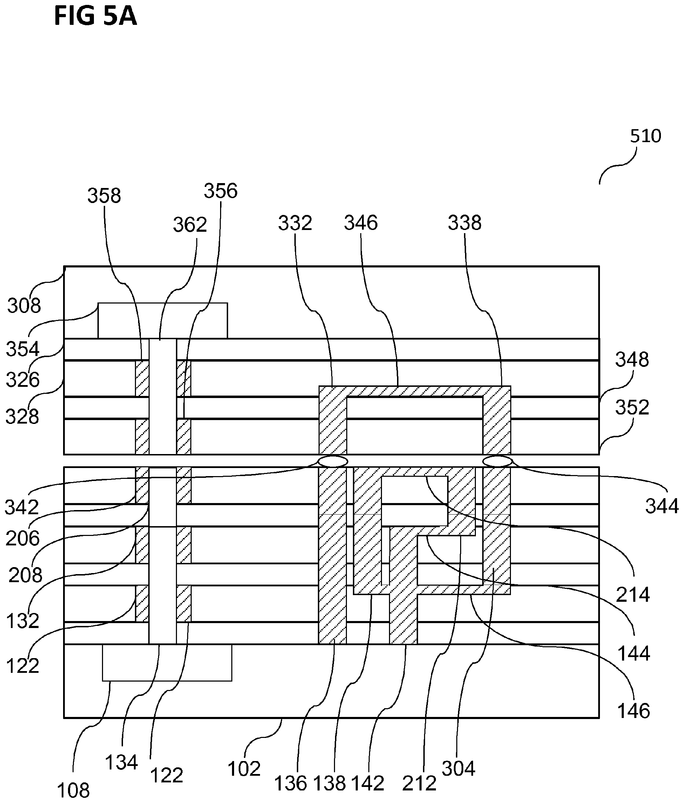

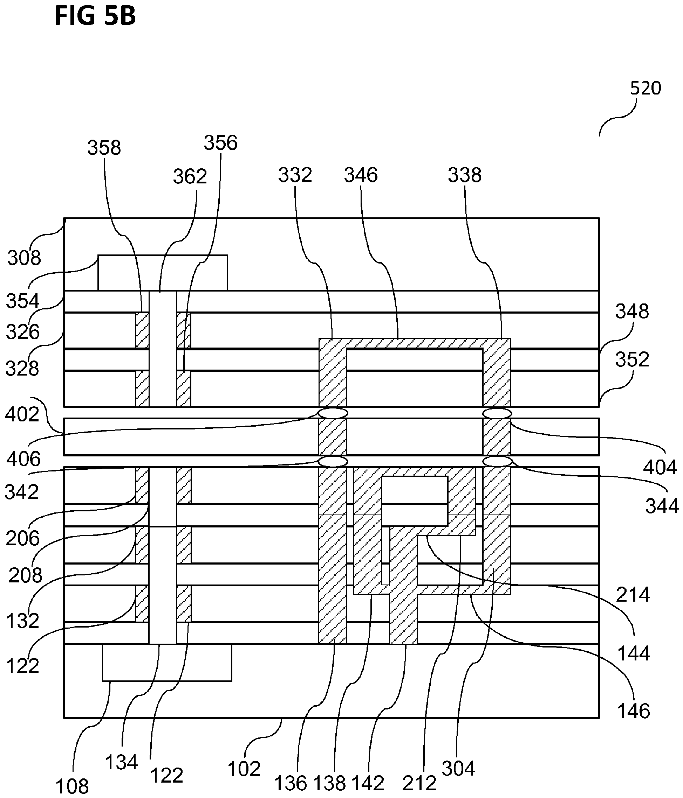

**Fig.5A** **und** **Fig.5B** zeigen eine Bauelementanordnung gemäß einer weiteren Ausführungsform.

In den **Fig.5A** **und** **Fig.5B** bezeichnen gleiche Bezugszeichen die gleichen Teile und/oder die gleichen Merkmale, wie sie oben in Bezug auf die **Fig.1A bis Fig.1E** und/oder die **Fig.2A bis Fig.2C** und/oder die **Fig.3A bis Fig.3F** und/oder der **Fig.4** beschrieben wurden. Im Folgenden werden im Wesentlichen nur noch die Unterschiede der Bauelementanordnung, wie sie in den Fig.3A bis Fig.3F dargestellt ist, zu der Bauelementanordnung, wie sie in den Fig.1A bis Fig.1E und/oder den Fig.2A bis Fig.2C und/oder den Fig.3A bis Fig.3F und/oder der Fig.4 dargestellt ist, erläutert. Hinsichtlich der anderen Merkmale wird auf die obigen Beispiele unter Fig.1A bis Fig.1E und/oder Fig.2A bis Fig.2C und/oder Fig.3A bis Fig.3F und/oder Fig.4 verwiesen.

In **Fig.5A****,** kann, gemäß einer Ausführungsform in einer Bauelementanordnung 510, die Bauelementanordnung 340, wie gezeigt in Fig.3D und oben beschrieben, angeordnet werden über und elektrisch leitend gekoppelt werden mit der ersten Bauelementanordnung 302, wie gezeigt in Fig.3A und oben beschrieben, unter Verwendung der Chipverbindungen 342, 344 und der mehreren zusätzlichen Durchkontaktierungen 332, 338.

Gemäß einer Ausgestaltung kann die erste zusätzliche Metallisierungsschicht 328 derart mit den mehren zusätzlichen Durchkontaktierungen 136, 138, 142, 212, 304 elektrisch leitend gekoppelt werden, dass zumindest ein Teil der ersten zusätzlichen Metallisierungsschicht 328 einen Teil der Spule bildet. In einem Beispiel kann die erste zusätzliche Metallisierungsschicht 328 derart elektrisch leitend gekoppelt werden mittels der mehreren zusätzlichen Durchkontaktierungen 136, 138, 142, 212, 304 unter Verwendung der Chipverbindungen 342, 344 und zumindest der zusätzlichen Leitungsstruktur 346, dass zumindest ein Teil der ersten zusätzlichen Metallisierungsschicht 328 einen Teil der Spule bildet.

Gemäß einer Ausgestaltung können die Chipverbindungen 342, 344 gebildet werden mittels verschiedener herkömmlicher Verfahren, wie oben beschrieben in 330. In einer Ausgestaltung können die Chipverbindungen 342, 344 gebildet werden mittels Lötens, z.B. unter Verwendung eines Lotes, beispielsweise unter Verwendung eines elektrisch leitfähigen Lotes, z.B. eines Weichlotes, z.B. eines Diffusionslotes. In einer anderen Ausgestaltung können die Chipverbindungen 336, 338 gebildet werden mittels Klebens, beispielsweise unter Verwendung eines Klebers, z.B. eines elektrisch leitfähigen Klebers, z.B. eines elektrisch isotrop leitfähigen Klebers, z.B. eines elektrisch anisotrop leitfähigen Klebers.

Gemäß einer Ausgestaltung kann in Fig. 5B (in 520) die Bauelementanordnung 340, wie gezeigt in Fig.3D und oben beschrieben, angeordnet werden über der ersten Bauelementanordnung 302, wie gezeigt in Fig.3A und oben beschrieben, unter Verwendung des Zwischenträgers 402, welcher die Mehrzahl von Zwischenträger-Durchkontaktierungen 404 aufweist, sowie der Mehrzahl von Chipverbindungen 342, 344, 366, 368 und einer Mehrzahl von Chipverbindungen 406.

Gemäß einer Ausgestaltung kann der Zwischenträger 402 (interposer) mindestens eines aus der nachfolgenden Gruppe an Materialien aufweisen: Silizium, Glas, einem elektrisch isolierenden Polymer. Der Zwischenträger 402 kann mit Hilfe verschiedener herkömmlicher Verfahren bereitgestellt werden, zum Beispiel mittels Silizium-Interposer-Technologie.

In einer Ausgestaltung, wie gezeigt in 520, kann der Zwischenträger 402 die Mehrzahl von Zwischenträger-Durchkontaktierungen 404 aufweisen, welche gebildet werden kann mit Hilfe verschiedener herkömmlicher Verfahren wie oben beschrieben in Bezug auf die Fig.4. Die Mehrzahl von Zwischenträger-Durchkontaktierungen 404 kann mit dem dritten elektrisch leitfähigen Material gefüllt werden. Das dritte elektrisch leitfähige Material dasselbe oder ein drittes elektrisch leitfähiges Material aufweisen wie das dritte elektrisch leitfähige Material der mindestens einen Durchkontaktierung 134 und/oder der mindestens einen Durchkontaktierung 208 und/oder der mehreren Durchkontaktierungen 136, 138, 142, 212, 304 und/oder der mehreren Silizium-Durchkontaktierungen 316, 318, 322, 324 und/oder der mehreren zusätzlichen Durchkontaktierungen 332, 334, 336, 338.

Gemäß einer Ausgestaltung kann zumindest die erste zusätzliche Metallisierungsschicht 328 derart mit den mehren zusätzlichen Durchkontaktierungen 136, 138, 142, 212, 304 elektrisch leitend gekoppelt werden, dass zumindest ein Teil der ersten zusätzlichen Metallisierungsschicht 328 einen Teil der Spule 152 bildet. In einem Beispiel kann die erste zusätzliche Metallisierungsschicht 328 unter Verwendung der zusätzlichen Leitungsstruktur 346 derart elektrisch leitend gekoppelt werden mittels der mehreren zusätzlichen Durchkontaktierungen 136, 138, 142, 212, 304 unter Verwendung der Mehrzahl von Chipverbindungen 342, 344 und der Mehrzahl von Chipverbindungen 406 sowie dem Zwischenträger 402, aufweisend eine Mehrzahl von Zwischenträger-Durchkontaktierungen 404, dass zumindest ein Teil der ersten zusätzlichen Metallisierungsschicht 328 einen Teil der Spule bildet.

Gemäß einer Ausgestaltung kann die Mehrzahl von Chipverbindungen 342, 344 und/oder die Mehrzahl von Chipverbindungen 406 gebildet werden mittels verschiedener herkömmlicher Verfahren, wie oben beschrieben in Bezug auf Fig.4

## Patentansprüche

1. Bauelementanordnung, aufweisend:
• einen Träger (102), wobei in dem Träger (102) mindestens ein elektronisches Bauelement (108) gebildet ist;
• eine erste Metallisierungsschicht (116) über dem Träger (102), wobei die erste Metallisierungsschicht (116) eine erste metallische Kopplungsstruktur (122) aufweist, die mit dem mindestens einen elektronischen Bauelement (108) gekoppelt ist;
• eine zweite Metallisierungsschicht (128) über der ersten Metallisierungsschicht (116), wobei die zweite Metallisierungsschicht (128) eine zweite metallische Kopplungsstruktur (132) aufweist, wobei die erste metallische Kopplungsstruktur (122) mittels mindestens einer Durchkontaktierung (134) mit der zweiten metallischen Kopplungsstruktur (132) gekoppelt ist;
• mehrere zusätzliche Durchkontaktierungen (136, 138, 212, 304, 332, 334, 336, 338), die sich zumindest zwischen der ersten Metallisierungsschicht (116) und der zweiten Metallisierungsschicht (128) erstrecken und die miteinander elektrisch leitend gekoppelt sind derart, dass sie eine Spule (152) bilden, die einen Spulenbereich (154) aufweist, der in einem Winkel zu der Hauptprozessierungsoberfläche des Trägers (102) liegt;
• eine dritte Metallisierungsschicht (204) über der zweiten Metallisierungsschicht (128), wobei die dritte Metallisierungsschicht (204) eine dritte metallische Kopplungsstruktur (206) aufweist, wobei die zweite metallische Kopplungsstruktur (132) mittels mindestens einer Durchkontaktierung (134, 208) mit der dritten metallischen Kopplungsstruktur (206) gekoppelt ist; und
• wobei sich einige der zusätzlichen Durchkontaktierungen (136, 138, 212, 304, 332, 334, 336, 338) zumindest zwischen der ersten Metallisierungsschicht (116) und der dritten Metallisierungsschicht (204) erstrecken;
• wobei die Spule (152) mehrere Spulenwindungen aufweist;
• wobei die mindestens zwei Spulenwindungen den Spulenbereich (154) definieren;
• wobei sich die mehreren zusätzlichen Durchkontaktierungen (136, 138, 212, 304, 332, 334, 336, 338) derart zumindest zwischen der ersten Metallisierungsschicht (116) und der zweiten Metallisierungsschicht erstrecken (128), dass der Spulenbereich (154) in einem Winkel grösser als 0° bis zu 85° zu der Hauptprozessierungsoberfläche des Trägers liegt;
• mindestens einen zusätzlichen Träger (308);
• eine erste zusätzliche Metallisierungsschicht (328) über dem zusätzlichen Träger (308);
• wobei die erste zusätzliche Metallisierungsschicht (328) mit mindestens einigen der mehreren zusätzlichen Durchkontaktierungen (136, 138, 212, 304, 332, 334, 336, 338) gekoppelt ist, so dass ein Teil der ersten zusätzlichen Metallisierungsschicht (328) einen Teil der Spule (152) bildet.

2. Bauelementanordnung gemäß Anspruch 1,
wobei die Träger (102, 308) ein Halbleitermaterial aufweisen.

3. Bauelementanordnung gemäß Anspruch 1 oder 2,
wobei die erste metallische Kopplungsstruktur (122) und/oder die zweite metallische Kopplungsstruktur (132) eine Mehrzahl von Metallleiterbahnen aufweist.

4. Bauelementanordnung gemäß einem der Ansprüche 1 bis 3,
wobei die erste metallische Kopplungsstruktur (122) und/oder die zweite metallische Kopplungsstruktur (132) mindestens eines der folgenden Metalle aufweist: Kupfer, Aluminium, Platin, Gold, Silber, Palladium, Nickel, oder eine Legierung der genannten Metalle.

5. Bauelementanordnung gemäß Anspruch 1 bis 4, ferner aufweisend:
eine zweite zusätzliche Metallisierungsschicht (352) über der ersten zusätzlichen Metallisierungsschicht (328), wobei die zweite zusätzliche Metallisierungsschicht (352) mit der ersten zusätzlichen Metallisierungsschicht (328) elektrisch gekoppelt ist, wobei ein Teil der zweiten zusätzlichen Metallisierungsschicht (352) einen Teil der Spule (152) bildet.

6. Bauelementanordnung gemäß Anspruch 1 bis 5,
wobei in dem zusätzlichen Träger (308) mindestens ein zusätzliches elektronisches Bauelement (354) gebildet ist.

7. Bauelementanordnung gemäß Anspruch 5 oder 6, ferner aufweisend:
mehrere weitere zusätzliche Durchkontaktierungen (136, 138, 212, 304, 332, 334, 336, 338), die sich zumindest zwischen der ersten zusätzlichen Metallisierungsschicht (328) und der zweiten zusätzlichen Metallisierungsschicht (352) erstrecken und die einen Teil der Spule (152) bilden.

8. Bauelementanordnung gemäß einem der Ansprüche 1 bis 7, ferner aufweisend:
• einen Zwischenträger (402) mit mehreren Zwischenträger-Durchkontaktierungen (404);
• wobei die Zwischenträger-Durchkontaktierungen (404) einen Teil der Spule bilden.

## Claims

1. Component arrangement, comprising:
• a carrier (102), wherein at least one electronic component (108) is formed in the carrier (102);
• a first metallization layer (116) above the carrier (102), wherein the first metallization layer (116) has a first metallic coupling structure (122) which is coupled to the at least one electronic component (108);
• a second metallization layer (128) above the first metallization layer (116), wherein the second metallization layer (128) has a second metallic coupling structure (132), wherein the first metallic coupling structure (122) is coupled to the second metallic coupling structure (132) by means of at least one via (134);
• a plurality of additional vias (136, 138, 212, 304, 332, 334, 336, 338) which extend at least between the first metallization layer (116) and the second metallization layer (128) and which are coupled to one another in an electrically conducting manner in such a way that they form a coil (152) which has a coil region (154) which is situated at an angle with respect to the main processing surface of the carrier (102);
• a third metallization layer (204) above the second metallization layer (128), wherein the third metallization layer (204) has a third metallic coupling structure (206), wherein the second metallic coupling structure (132) is coupled to the third metallic coupling structure (206) by means of at least one via (134, 208); and
• wherein some of the additional vias (136, 138, 212, 304, 332, 334, 336, 338) extend at least between the first metallization layer (116) and the third metallization layer (204);
• wherein the coil (152) has a plurality of coil windings;
• wherein the at least two coil windings define the coil region (154);
• wherein the plurality of additional vias (136, 138, 212, 304, 332, 334, 336, 338) extend at least between the first metallization layer (116) and the second metallization layer (128) in such a way that the coil region (154) is situated at an angle of greater than 0° to 85° with respect to the main processing surface of the carrier;
• at least one additional carrier (308);
• a first additional metallization layer (328) above the additional carrier (308);
• wherein the first additional metallization layer (328) is coupled to at least some of the plurality of additional vias (136, 138, 212, 304, 332, 334, 336, 338), with the result that a part of the first additional metallization layer (328) forms a part of the coil (152).

2. Component arrangement according to Claim 1, wherein the carriers (102, 308) contain a semiconductor material.

3. Component arrangement according to Claim 1 or 2,
wherein the first metallic coupling structure (122) and/or the second metallic coupling structure (132) have/has a plurality of metal conductor tracks.

4. Component arrangement according to one of Claims 1 to 3,
wherein the first metallic coupling structure (122) and/or the second metallic coupling structure (132) contain/contains at least one of the following metals: copper, aluminium, platinum, gold, silver, palladium, nickel, or an alloy of said metals.

5. Component arrangement according to Claims 1 to 4, further comprising:
a second additional metallization layer (352) above the first additional metallization layer (328), wherein the second additional metallization layer (352) is electrically coupled to the first additional metallization layer (328), wherein a part of the second additional metallization layer (352) forms a part of the coil (152).

6. Component arrangement according to Claims 1 to 5, wherein at least one additional electronic component (354) is formed in the additional carrier (308).

7. Component arrangement according to Claim 5 or 6, further comprising:
a plurality of further additional vias (136, 138, 212, 304, 332, 334, 336, 338) which extend at least between the first additional metallization layer (328) and the second additional metallization layer (352) and which form a part of the coil (152).

8. Component arrangement according to one of Claims 1 to 7, further comprising:
• an intermediate carrier (402) having a plurality of intermediate carrier vias (404);
• wherein the intermediate carrier vias (404) form a part of the coil.

## Revendications

1. Agencement de composants présentant :
- un support (102), un ou plusieurs composants électroniques (108) étant formé dans le support (102),
- une première couche de métallisation (116) disposée au-dessus du support (102), la première couche de métallisation (116) présentant une première structure métallique de raccordement (122) raccordée au ou aux composants électroniques (108),
- une deuxième couche de métallisation (128) recouvrant la première couche de métallisation (116), la deuxième couche de métallisation (128) présentant une deuxième structure métallique de raccordement (132), la première structure métallique de raccordement (122) étant raccordée à la deuxième structure métallique de raccordement (132) au moyen d'une ou plusieurs traversées de mise en contact (134),
- plusieurs traversées supplémentaires de mise en contact (136, 138, 212, 304, 332, 334, 336, 338) qui s'étendent au moins entre la première couche de métallisation (116) et la deuxième couche de métallisation (128) et qui sont raccordées les unes aux autres de manière électriquement conductrice de manière à former une inductance (152) qui présente une partie en inductance (154) disposée obliquement par rapport à la surface principale de traitement du support (102),
- une troisième couche de métallisation (204) qui recouvre la deuxième couche de métallisation (128), la troisième couche de métallisation (204) présentant une troisième structure métallique de raccordement (206), la deuxième structure métallique de raccordement (132) étant raccordée à la troisième structure métallique de raccordement (206) au moyen d'au moins une traversée de mise en contact (134, 208),
- certaines des traversées supplémentaires de mise en contact (136, 138, 212, 304, 332, 334, 336, 338) s'étendant au moins entre la première couche de métallisation (116) et la troisième couche de métallisation (204),
- l'inductance (152) présentant plusieurs enroulements d'inductance,
- les deux ou plusieurs enroulements d'inductance définissant la partie en inductance (154),
- les différents traversées supplémentaires de mise en contact (136, 138, 212, 304, 332, 334, 336, 338) s'étendant au moins entre la première couche de métallisation (116) et la deuxième couche de métallisation (128) de telle sorte que la partie en inductance (154) forme avec la surface principale de traitement du support un angle supérieur à 0° et pouvant atteindre 85°,
- au moins un support supplémentaire (308),
- une première couche supplémentaire de métallisation (328) recouvrant le support supplémentaire (308),
- la première couche supplémentaire de métallisation (328) étant raccordée à au moins certaines des traversées supplémentaires de mise en contact (136, 138, 212, 304, 332, 334, 336, 338) de telle sorte qu'une partie de la première couche supplémentaire de métallisation (328) forme une partie de l'inductance (152) .

2. Agencement de composants selon la revendication 1, dans lequel les supports (102, 308) présentent un matériau semiconducteur.

3. Agencement de composants selon les revendications 1 ou 2, dans lequel la première structure métallique de raccordement (122) et/ou la deuxième structure métallique de raccordement (132) présentant plusieurs pistes métalliques conductrices.

4. Agencement de composants selon l'une des revendications 1 à 3, dans lequel la première structure métallique de raccordement (122) et/ou la deuxième structure métallique de raccordement (132) présentent un ou plusieurs des métaux suivants : cuivre, aluminium, platine, or, argent, palladium, nickel ou un alliage desdits métaux.

5. Agencement de composants selon l'une des revendications 1 à 4, présentant en outre :
une deuxième couche supplémentaire de métallisation (352) qui recouvre la première couche supplémentaire de métallisation (328), la deuxième couche supplémentaire de métallisation (352) étant raccordée électriquement à la première couche supplémentaire de métallisation (328), une partie de la deuxième couche supplémentaire de métallisation (352) formant une partie de l'inductance (152).

6. Agencement de composants selon les revendications 1 à 5, dans lequel un ou plusieurs composants électroniques supplémentaires (354) sont formés dans le support supplémentaire (308).

7. Agencement de composants selon les revendications 5 ou 6, présentant :
plusieurs autres traversées supplémentaires de mise en contact (136, 138, 212, 304, 332, 334, 336, 338) qui s'étendent au moins entre la première couche supplémentaire de métallisation (328) et la deuxième couche supplémentaire de métallisation (352) et qui forment une partie de l'inductance (152).

8. Agencement de composants selon l'une des revendications 1 à 7, présentant en outre :
- un support intermédiaire (402) doté de plusieurs traversées de mise en contact (404) de support intermédiaire,
- les traversées de mise en contact (404) de support intermédiaire formant une partie de l'inductance.
